(19) **Europäisches Patentamt / European Patent Office / Office européen des brevets**

(11) **EP 1 989 704 B1**

(12) **EUROPEAN PATENT SPECIFICATION**

(45) Date of publication and mention
of the grant of the patent:
**16.10.2013 Bulletin 2013/42**

(21) Application number: **07708761.7**

(22) Date of filing: **05.02.2007**

(51) Int Cl.:
*G10L 19/008* (2013.01)     *H04S 7/00* (2006.01)

(86) International application number:
**PCT/KR2007/000611**

(87) International publication number:
**WO 2007/089131 (09.08.2007 Gazette 2007/32)**

(54) **METHOD AND APPARATUS FOR CONTROL OF RANDERING MULTIOBJECT OR MULTICHANNEL AUDIO SIGNAL USING SPATIAL CUE**

VERFAHREN UND VORRICHTUNG ZUR STEUERUNG DER WIEDERGABE EINES MEHRFACHOBJEKTS ODER MEHRFACHKANAL-AUDIOSIGNALS UNTER VERWENDUNG EINES RÄUMLICHEN HINWEISES

PROCEDE ET APPAREIL DESTINES A REGULER LA RESTITUTION D'UN SIGNAL AUDIO MULTI-OBJET OU MULTI-CANAL AU MOYEN D'UN REPERE SPATIAL

(84) Designated Contracting States:
**AT BE BG CH CY CZ DE DK EE ES FI FR GB GR HU IE IS IT LI LT LU LV MC NL PL PT RO SE SI SK TR**

(30) Priority: **03.02.2006   KR 20060010559**
**29.03.2006   US 786999 P**
**11.07.2006   US 830052 P**
**11.07.2006   US 819907 P**
**14.07.2006   KR 20060066488**
**25.07.2006   KR 20060069961**
**08.01.2007   KR 20070001996**

(43) Date of publication of application:
**12.11.2008   Bulletin 2008/46**

(60) Divisional application:
**12180406.6 / 2 528 058**
**13167525.8 / 2 629 292**

(73) Proprietor: **Electronics and Telecommunications Research Institute**
**Yuseong-gu**
**Daejon 305-350 (KR)**

(72) Inventors:
• **BEACK, Seung-Kwon**
**Daejon 305-340 (KR)**
• **SEO, Jeong-Il**
**Daejon 305-728 (KR)**
• **JANG, Dae-Young**
**Daejon 305-768 (KR)**
• **LEE, Tae-Jin**
**Daejon 305-752 (KR)**
• **LEE, Yong-Ju**
**Daejon 305-345 (KR)**
• **HONG, Jin-Woo**
**Daejon 305-340 (KR)**
• **KIM, Jin-Woong**
**Daejon 305-761 (KR)**

(74) Representative: **Betten & Resch**
**Theatinerstrasse 8**
**80333 München (DE)**

(56) References cited:
**WO-A1-2004/036954**

• **"Text of ISO/IEC 23003-1:200x MPEG Surround", 74. MPEG MEETING;17-10-2005 - 21-10-2005; NICE; (MOTION PICTURE EXPERTGROUP OR ISO/IEC JTC1/SC29/WG11),, no. N7530, 21 October 2005 (2005-10-21), XP030014078, ISSN: 0000-0344**
• **HAN-GIL MOON: "Multi-channel audio compression method with virtual source location information for MPEG-4 SAC", INTERNET CITATION, 1 February 2005 (2005-02-01), pages I-XIII, XP002605438, Retrieved from the Internet: URL:http://library.snu.ac.kr/Eng/DetailVie w.jsp?uid=1&cid=1198524&ResultT ype=Multi [retrieved on 2010-08-16]**

- PASI OJALA: "New use cases for spatial audio coding", 75. MPEG MEETING; 16-01-2006 - 20-01-2006; BANGKOK; (MOTION PICTUREEXPERT GROUP OR ISO/IEC JTC1/SC29/WG11),, no. M12913, 11 January 2006 (2006-01-11), XP030041582, ISSN: 0000-0240
- JANG INSEON ET AL: "Spatial Audio Coding System Based on Virtual Source Location Information", AES CONVENTION 119; OCTOBER 2005, AES, 60 EAST 42ND STREET, ROOM 2520 NEW YORK 10165-2520, USA, 1 October 2005 (2005-10-01), XP040507404,
- BEACK SEUNGKWON ET AL: "Multichannel Sound Scene Control For MPEG Surround", CONFERENCE: 29TH INTERNATIONAL CONFERENCE: AUDIO FOR MOBILE AND HANDHELD DEVICES; SEPTEMBER 2006, AES, 60 EAST 42ND STREET, ROOM 2520 NEW YORK 10165-2520, USA, 1 September 2006 (2006-09-01), XP040507968,
- SEUNGKWON BEACK ET AL: "Spatial Cue Based Sound Scene Control for MPEG Surround", MULTIMEDIA AND EXPO, 2007 IEEE INTERNATIONAL CONFERENCE ON, IEEE, PI, 1 July 2007 (2007-07-01), pages 1886-1889, XP031124018, ISBN: 978-1-4244-1016-3
- SEUNGKWON BEACK ET AL: "CE on Multi-channel Sound Scene Control for MPEG Surround", 76. MPEG MEETING; 03-04-2006 - 07-04-2006; MONTREUX; (MOTION PICTUREEXPERT GROUP OR ISO/IEC JTC1/SC29/WG11),, no. M13160, 29 March 2006 (2006-03-29), XP030041829, ISSN: 0000-0239
- JEONGIL SEO ET AL: "CE on Multi-channel Visualization for MPEG Surround", 76. MPEG MEETING; 03-04-2006 - 07-04-2006; MONTREUX; (MOTION PICTUREEXPERT GROUP OR ISO/IEC JTC1/SC29/WG11),, no. M13161, 29 March 2006 (2006-03-29), XP030041830, ISSN: 0000-0239
- SEUNGKWON BEACK ET AL: "Consideration on audio image control in binaural decoder", 77. MPEG MEETING; 17-07-2006 - 21-07-2006; KLAGENFURT; (MOTION PICTUREEXPERT GROUP OR ISO/IEC JTC1/SC29/WG11),, no. M13558, 12 July 2006 (2006-07-12), XP030042227, ISSN: 0000-0236
- BREEBAART J. ET AL.: 'MPEG Spatial Audio Coding/MPEG Surround: Overview and Current Status' PROC. 119TH AES CONVENTION. NEW YORK 07 October 2005, pages 1 - 15, XP002364486
- FALLER C. ET AL.: 'Parametric coding of spatial audio' LAUSANNE: EPFL 2004, pages 1 - 164, XP003015825
- VAANANEN R.: 'User Interaction and Authoring of 3D Sound Scenes in the Carrouso EU project' PROC. 114TH AES CONVENTION. AMSTERDAM March 2003, pages 1 - 9, XP008083941

**Description**

**TECHNICAL FIELD**

The present invention relates to control of rendering multi-object or multi-channel audio signals; and more particularly to a method and apparatus for controlling the rendering of multi-object or multi-channel audio signals based on a spatial cue when the multi-object or multi-channel audio signals are decoded.

**BACKGROUND ART**

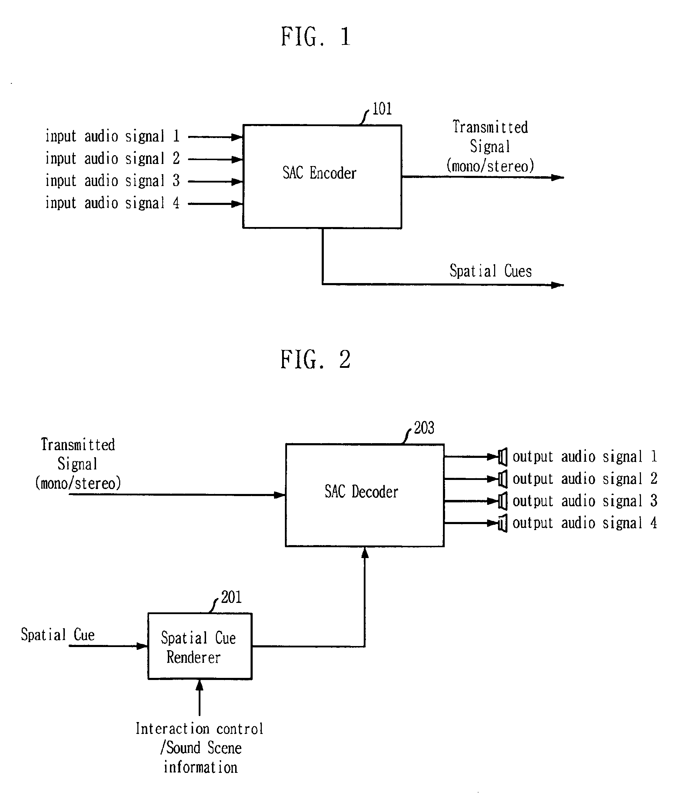

Fig. 1 illustrates an example of a conventional encoder for encoding multi-object or multi-channel audio signals. Referring to the drawing, a Spatial Audio Coding (SAC) encoder 101 is presented as an example of a conventional multi-object or multi-channel audio signal encoder, and it extracts spatial cues, which are to be described later, from the input signals, i.e., multi-object or multi-channel audio signals and transmits the spatial cues, while down-mixing the audio signals and transmits them in the form of mono or stereo signals.

SAC technology relates to a method of representing multi-object or multi-channel audio signals as down-mixed mono or stereo signals and spatial cue information, and transmitting and recovering them. The SAC technology can transmit high-quality multi-channel signals even at a low bit rate. The SAC technology focuses on analyzing multi-object or multi-channel audio signals according to each sub-band, and recovering original signals from the down-mixed signals based on the spatial cue information for each sub-band. Thus, the spatial cue information includes significant information needed for recovering the original signals in a decoding process, and the information becomes a major factor that determines the sound quality of the audio signals recovered in an SAC decoding device. Moving Picture Experts Group (MPEG) based on SAC technology is undergoing standardization in the name of MPEG Surround, and Channel Level Difference (CLD) is used as spatial cue.

The present invention is directed to an apparatus and method for controlling rendering of multi-object or multi-channel audio signals based on spatial cue transmitted from an encoder, while the multi-object or multi-channel audio signals are down-mixed and transmitted from the encoder and decoded.

Conventionally, a graphic equalizer equipped with a frequency analyzer was usually utilized to recover mono or stereo audio signals. The multi-object or multi-channel audio signals can be positioned diversely in a space. However, the positions of audio signals generated from the multi-object or multi-channel audio signals are recognized and recovered uniquely to a decoding device in the current technology.

"Text of ISO/IEC 23003-1: 200x MPEG Surround", 74. MPEG MEETING; 17-10-2005-21-10-2005; NICE; (MOTION PICTURE EXPERTGROUP OR ISO/IEC JTC1/SC29/WG11), no. N7530, 21 October 2005 (2005-10-21) is a working draft distributed for review and comment describes decoding processes for spatial audio coded information for the MPEG standard.

The thesis "Multi-channel audio compression method with virtual source location information for MPEG-4 SAC", Feb. 1, 2005, by Han-Gil Moon proposes a spatial coding system equipped with Virtual Source Location Information (VSLI) as an alternative to the conventional Binaural Cue Coding (BCC) system for MPEG-4 SAC.

**DISCLOSURE**

**TECHNICAL PROBLEM**

An embodiment of the present invention is directed to providing an apparatus and method for controlling rendering of multi-object or multi-channel audio signals based on spatial cue, when the multi-object or multi-channel audio signals are decoded.

Other objects and advantages of the present invention can be understood by the following description, and become apparent with reference to the embodiments of the present invention. Also, it is obvious to those skilled in the art of the present invention that the objects and advantages of the present invention can be realized by the means as claimed and combinations thereof.

**TECHNICAL SOLUTION**

In accordance with an aspect of the present invention, there is provided an apparatus as claimed in claim 1 for controlling rendering of audio signals, which includes: a decoder for decoding an input audio signal, which is a down-mixed signal that is encoded in a Spatial Audio Coding (SAC) method, by using an SAC decoding method; and a spatial cue renderer for receiving spatial cue information and control information on rendering of the input audio signal and controlling the spatial cue information in a spatial cue domain based on the control information. Herein, the decoder performs rendering onto the input audio signals based on a controlled spatial cue information controlled by the spatial cue renderer.

In accordance with another aspect of the present invention, there is provided an apparatus for controlling rendering of audio signals, which includes: a decoder for decoding an input audio signal, which is a down-mixed signal encoded in an SAC method, by using the SAC method; and a spatial cue renderer for receiving spatial cue information and control information on the rendering of the input audio signal and controlling the spatial cue information in a spatial cue domain based on the control information. Herein, the decoder performs rendering of the input audio signal based on spatial cue information controlled by the spatial cue renderer, and the spatial cue information is a Channel Level Difference (CLD) value representing a level difference between input audio signals and expressed as

$$D_{CLD}^{Q}(ott,l,m).$$ The spatial cue renderer includes: a CLD parsing unit for extracting a CLD parameter from a CLD transmitted from an encoder; a gain factor conversion unit for extracting a power gain of each audio signal from the CLD parameter extracted from the CLD parsing unit; and a gain factor control unit for calculating a controlled power gain by controlling a power gain of each audio signal extracted in the gain factor conversion unit based on control information on rendering of the input audio signal, m denoting an index of a sub-band and 1 denoting an index of a parameter set in the $D_{CLD}^{Q}(ott,l,m).$

In accordance with another aspect of the present invention, there is provided an apparatus for controlling rendering of audio signals, which includes: a decoder for decoding an input audio signal, which is a down- mixed signal encoded in a Spatial Audio Coding (SAC) method, by using the SAC method; and a spatial cue renderer for receiving spatial cue information and control information on the rendering of the input audio signal and controlling the spatial cue information in a spatial cue domain based on the control information. Herein, the decoder performs rendering of the input audio signal based on spatial cue information controlled by the spatial cue renderer, and a center signal (C), a left half plane signal (Lf+Ls) and a right half plane signal (Rf+Rs) are extracted from the down- mixed signals L0 and R0, and the spatial cue information is a CLD value representing a level difference between input audio signals and expressed as $CLD_{LR/Clfe}$, $CLD_{L/R}$, $CLD_{C/lfe}$, $CLD_{Lf/Ls}$ and $CLD_{Rf/Rs}$. The spatial cue renderer includes: a CLD parsing unit for extracting a CLD parameter from a CLD transmitted from an encoder; a gain factor conversion unit for extracting a power gain of each audio signal from the CLD parameter extracted from the CLD parsing unit; and a gain factor control unit for calculating a controlled power gain by controlling a power gain of each audio signal extracted in the gain factor conversion unit based on control information on rendering of the input audio signal.

In accordance with another aspect of the present invention, there is provided an apparatus as claimed in claim 14 for controlling rendering of audio signals, which includes: a decoder for decoding an input audio signal, which is a down-mixed signal encoded in an SAC method, by using the SAC method; and a spatial cue renderer for receiving spatial cue information and control information on the rendering of the input audio signal and controlling the spatial cue information in a spatial cue domain based on the control information. Herein, the decoder performs rendering of the input audio signal based on spatial cue information controlled by the spatial cue renderer, and the spatial cue information is a CLD value representing a level difference between input audio signals and a Channel Prediction Coefficient (CPC) representing a down-mixing ratio of input audio signals. The spatial cue renderer includes: a CPC/CLD parsing unit for extracting a CPC parameter and a CLD parameter from a CPC and a CLD transmitted from an encoder; a gain factor conversion unit for extracting power gains of each signal by extracting a center signal, a left half plane signal, and a right half plane signal from the CPC parameter extracted in the CPC/CLD parsing unit, and extracting power gains of left signal components and right signal components from the CLD parameter; and a gain factor control unit for calculating a controlled power gain by controlling a power gain of each audio signal extracted in the gain factor conversion unit based on control information on rendering of the input audio signal.

In accordance with another aspect of the present invention, there is provided an apparatus for controlling rendering of audio signals, which includes: a decoder for decoding an input audio signal, which is a down-mixed signal encoded in an SAC method, by using the SAC method; and a spatial cue renderer for receiving spatial cue information and control information on the rendering of the input audio signal and controlling the spatial cue information in a spatial cue domain based on the control information. Herein, the decoder performs rendering of the input audio signal based on spatial cue information controlled by the spatial cue renderer, and the spatial cue information is an Inter-Channel Correlation (ICC) value representing a correlation between input audio signals, and the spatial cue renderer controls an ICC parameter through a linear interpolation process.

In accordance with another aspect of the present invention, there is provided a method as claimed in claim 22 for controlling rendering of audio signals, which includes the steps of: a) decoding an input audio signal, which is a down-mixed signal that is encoded in an SAC method, by using an SAC decoding method; and b) receiving spatial cue information and control information on rendering of the input audio signals and controlling the spatial cue information in a spatial cue domain based on the control information. Herein, rendering is performed in the decoding step a) onto the input audio signals based on a controlled spatial cue information controlled in the spatial cue rendering step b).

In accordance with another aspect of the present invention, there is provided a method for controlling rendering of audio signals, which includes the steps of: a) decoding an input audio signal, which is a down-mixed signal encoded in an SAC method, by using the SAC method; and b) receiving spatial cue information and control information on the rendering of the input audio signal and controlling the spatial cue information in a spatial cue domain based on the control information. Herein, rendering of the input audio signal is performed in the decoding step a) based on spatial cue information controlled in the spatial cue rendering step b), and the spatial cue information is a CLD value representing a level difference between input audio signals and expressed as $D_{CLD}^{Q}(ott, l, m)$. Herein, the spatial cue rendering step b) includes the steps of: b1) extracting a CLD parameter from a CLD transmitted from an encoder; b2) extracting a power gain of each audio signal from the CLD parameter extracted from the CLD parsing step b1); and b3) calculating a controlled power gain by controlling a power gain of each audio signal extracted in the gain factor conversion step b2) based on control information on rendering of the input audio signal, m denoting an index of a sub-band and 1 denoting an index of a parameter set in the $D_{CLD}^{Q}(ott, l, m)$.

In accordance with another aspect of the present invention, there is provided a method for controlling rendering of audio signals, which includes the steps of: a) decoding an input audio signal, which is a down- mixed signal encoded in an SAC method, by using the SAC method; and b) receiving spatial cue information and control information on the rendering of the input audio signal and controlling the spatial cue information in a spatial cue domain based on the control information. Herein, rendering of the input audio signal is performed in the decoding step a) based on spatial cue information controlled in the spatial cue rendering step b), and a center signal (C), a left half plane signal (Lf+Ls) and a right half plane signal (Rf+Rs) are extracted from the down- mixed signals L0 and R0, and the spatial cue information is a CLD value representing a level difference between input audio signals and expressed as $CLD_{LR/Clfe}$, $CLD_{L/R}$, $CLD_{C/lfe}$, $CLD_{Lf/Ls}$ and $CLD_{Rf/Rs}$. The spatial cue rendering step b) includes the steps of: b1) extracting a CLD parameter from a CLD transmitted from an encoder; b2) extracting a power gain of each audio signal from the CLD parameter extracted in the CLD parsing step b1) ; and b3) calculating a controlled power gain by controlling a power gain of each audio signal extracted in the gain factor conversion step b2) based on control information on rendering of the input audio signal.

In accordance with another aspect of the present invention, there is provided a method as claimed in claim 23 for controlling rendering of audio signals, which includes the steps of: a) decoding an input audio signal, which is a down-mixed signal encoded in an SAC method, by using the SAC method; and b) receiving spatial cue information and control information on the rendering of the input audio signal and controlling the spatial cue information in a spatial cue domain based on the control information. Herein, rendering of the input audio signal is performed in the decoding step a) based on spatial cue information controlled in the spatial cue rendering step b), and the spatial cue information is a CPC representing a down-mixing ratio of input audio signals and a CLD value representing a level difference between input audio signals. Herein, the spatial cue rendering step b) includes: b1) extracting a CPC parameter and a CLD parameter from a CPC and a CLD transmitted from an encoder; b2) extracting power gains of each signal by extracting a center signal, a left half plane signal, and a right half plane signal from the CPC parameter extracted in the CPC/CLD parsing step b1), and extracting a power gain of a left signal component and a right signal component from the CLD parameter; and b3) calculating a controlled power gain by controlling a power gain of each audio signal extracted in the gain factor conversion step b2) based on control information on rendering of the input audio signal.

In accordance with another aspect of the present invention, there is provided a method for controlling rendering of audio signals, which includes the steps of: a) decoding an input audio signal, which is a down-mixed signal encoded in an SAC method, by using the SAC method; and b) receiving spatial cue information and control information on the rendering of the input audio signal and controlling the spatial cue information in a spatial cue domain based on the control information. Herein, rendering of the input audio signal is performed in the decoding step a) based on spatial cue information controlled in the spatial cue rendering step b), and the spatial cue information is an Inter-Channel Correlation (ICC) value representing a correlation between input audio signals, and an ICC parameter is controlled in the spatial cue rendering step b) through a linear interpolation process.

According to the present invention, it is possible to flexibly control the positions of multi-object or multi-channel audio signals by directly controlling spatial cues upon receipt of a request from a user or an external system in communication.

## ADVANTAGEOUS EFFECTS

The present invention provides an apparatus and method for controlling rendering of multi-object or multi-channel signals based on spatial cues when the multi-object or multi-channel audio signals are decoded.

**BRIEF DESCRIPTION OF THE DRAWINGS**

Fig. 1 is an exemplary view showing a conventional multi-object or multi-channel audio signal encoder.

Fig. 2 shows an audio signal rendering controller in accordance with an embodiment of the present invention.

Fig. 3 is an exemplary view illustrating a recovered panning multi-channel signal.

Fig. 4 is a block diagram describing a spatial cue renderer shown in Fig. 2 when Channel Level Difference (CLD) is utilized as a spatial cue in accordance with an embodiment of the present invention.

Fig. 5 illustrates a method of mapping audio signals to desired positions by utilizing Constant Power Panning (CPP).

Fig. 6 schematically shows a layout including angular relationship between signals.

Fig. 7 is a detailed block diagram describing a spatial cue renderer in accordance with an embodiment of the present invention when an SAC decoder is in an MPEG Surround stereo mode.

Fig. 8 illustrates a spatial decoder for decoding multi-object or multi-channel audio signals.

Fig. 9 illustrates a three-dimensional (3D) stereo audio signal decoder, which is a spatial decoder.

Fig. 10 is a view showing an embodiment of a spatial cue renderer to be applied to Figs. 8 and 9.

Fig. 11 is a view illustrating a Moving Picture Experts Group (MPEG) Surround decoder adopting a binaural stereo decoding.

Fig. 12 is a view describing an audio signal rendering controller in accordance with another embodiment of the present invention.

Fig. 13 is a detailed block diagram illustrating a spatializer of Fig. 12.

Fig. 14 is a view describing a multi-channel audio decoder to which the embodiment of the present invention is applied.

**BEST MODE FOR THE INVENTION**

Following description exemplifies only the principles of the present invention. Even if they are not described or illustrated clearly in the present specification, one of ordinary skill in the art can embody the principles of the present invention and invent various apparatuses within the concept and scope of the present invention. The use of the conditional terms and embodiments presented in the present specification are intended only to make the concept of the present invention understood, and they are not limited to the embodiments and conditions mentioned in the specification.

In addition, all the detailed description on the principles, viewpoints and embodiments and particular embodiments of the present invention should be understood to include structural and functional equivalents to them. The equivalents include not only currently known equivalents but also those to be developed in future, that is, all devices invented to perform the same function, regardless of their structures.

For example, block diagrams of the present invention should be understood to show a conceptual viewpoint of an exemplary circuit that embodies the principles of the present invention. Similarly, all the flowcharts, state conversion diagrams, pseudo codes and the like can be expressed substantially in a computer-readable media, and whether or not a computer or a processor is described distinctively, they should be understood to express various processes operated by a computer or a processor.

Functions of various devices illustrated in the drawings including a functional block expressed as a processor or a similar concept can be provided not only by using hardware dedicated to the functions, but also by using hardware capable of running proper software for the functions. When a function is provided by a processor, the function may be provided by a single dedicated processor, single shared processor, or a plurality of individual processors, part of which can be shared.

The apparent use of a term, 'processor', 'control' or similar concept, should not be understood to exclusively refer to a piece of hardware capable of running software, but should be understood to include a digital signal processor (DSP), hardware, and ROM, RAM and non-volatile memory for storing software, implicatively. Other known and commonly used hardware may be included therein, too.

Similarly, a switch described in the drawings may be presented conceptually only. The function of the switch should be understood to be performed manually or by controlling a program logic or a dedicated logic or by interaction of the dedicated logic. A particular technology can be selected for deeper understanding of the present specification by a designer.

In the claims of the present specification, an element expressed as a means for performing a function described in the detailed description is intended to include all methods for performing the function including all formats of software, such as combinations of circuits for performing the intended function, firmware/microcode and the like.

To perform the intended function, the element is cooperated with a proper circuit for performing the software. The present invention defined by claims includes diverse means for performing particular functions, and the means are connected with each other in a method requested in the claims. Therefore, any means that can provide the function should be understood to be an equivalent to what is figured out from the present specification.

The advantages, features and aspects of the invention will become apparent from the following description of the embodiments with reference to the accompanying drawings, which is set forth hereinafter. If further detailed description on the related prior arts is determined to obscure the point of the present invention, the description is omitted. Hereafter, preferred embodiments of the present invention will be described in detail with reference to the drawings.

Fig. 2 shows an audio signal rendering controller in accordance with an embodiment of the present invention. Referring to the drawing, the audio signal rendering controller employs a Spatial Audio Coding (SAC) decoder 203, which is a constituent element corresponding to the SAC encoder 101 of Fig. 1, and it includes a spatial cue renderer 201 additionally.

A signal inputted to the SAC decoder 203 is a down-mixed mono or stereo signal transmitted from an encoder, e.g., the SAC encoder of Fig. 1. A signal inputted to the spatial cue renderer 201 is a spatial cue transmitted from the encoder, e.g., the SAC encoder of Fig. 1.

The spatial cue renderer 201 controls rendering in a spatial cue domain. To be specific, the spatial cue renderer 201 perform rendering not by directly controlling the output signal of the SAC decoder 203 but by extracting audio signal information from the spatial cue.

Herein, the spatial cue domain is a parameter domain where the spatial cue transmitted from the encoder is recognized and controlled as a parameter. Rendering is a process of generating output audio signal by determining the position and level of an input audio signal.

The SAC decoder 203 may adopt such a method as MPEG Surround, Binaural Cue Coding (BCC) and Sound Source Location Cue Coding (SSLCC), but the present invention is not limited to them.

According to the embodiment of the present invention, applicable spatial cues are defined as:

Channel Level Difference (CLD): Level difference  between input audio signals
Inter-Channel Correlation (ICC): Correlation between input audio signals
Channel Prediction Coefficient (CPC): Down-mixing ratio of an input audio signal

In other words, the CDC is power gain information of an audio signal, and the ICC is correlation information between audio signals. The CTD is time difference information between audio signals, and the CPC is down-mixing gain information of an audio signal.

Major role of a spatial cue is to maintain a spatial image, i.e., a sound scene. According to the present invention, a sound scene can be controlled by controlling the spatial cue parameters instead of directly manipulating an audio output signal.

When the reproduction environment of an audio signal is taken into consideration, the mostly used spatial cue is CLD, which alone can generate a basic output signal. Hereinafter, technology for controlling signals in a spatial cue domain will be described based on CLD as an embodiment of the present invention. The present invention, however, is not limited to the CLD and it is obvious to those skilled in the art to which the present invention pertains. Therefore, it should be understood that the present invention is not limited to the use of CLD.

According to an embodiment using CLD, multi-object and multi-channel audio signals can be panned by directly applying a law of sound panning to a power gain coefficient.

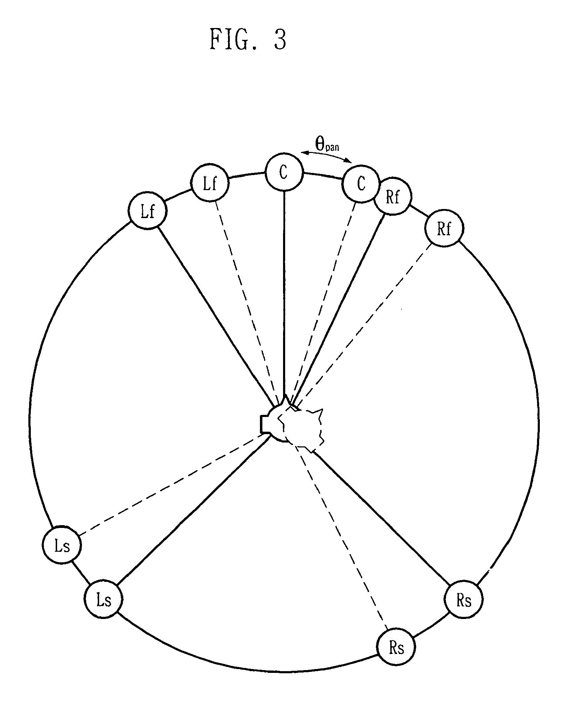

According to the embodiment, multi-object and multi-channel audio signals can be recovered based on the panning position in the entire band by controlling the spatial cue. The CLD is manipulated to assess the power  gain of each audio signal corresponding to a desired panning position. The panning position may be freely inputted through interaction control signals inputted from the outside. Fig. 3 is an exemplary view illustrating a recovered panning multi-channel signal. Each signal is rotated at a given angle $\theta_{pan}$. Then, the user can recognize rotated sound scenes. In Fig. 3, Lf denotes a left front channel signal; Ls denotes a left rear channel signal; Rf denotes a right front channel signal, Rs denotes a right rear channel signal; C denotes a central channel signal. Thus, [Lf+ Ls] denotes left half-plane signals, and [Rf+Rs] denotes right half-plane signals. Although not illustrated in Fig. 3, lfe indicates a woofer signal.

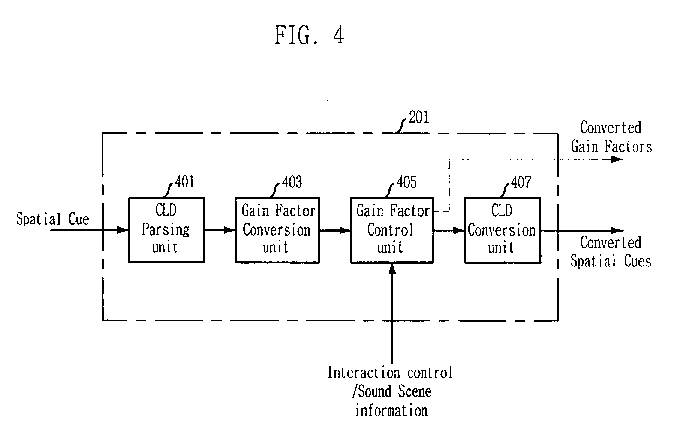

Fig. 4 is a block diagram describing a spatial cue renderer shown in Fig. 2 when CLD is utilized as a spatial cue in accordance with an embodiment of the present invention.

Referring to the drawing, the spatial cue renderer 201 using CLD as a spatial cue includes a CLD parsing unit 401, a gain factor conversion unit 403, a gain factor control unit 405, and a CLD conversion unit 407.

The CLD parsing unit 401 extracts a CLD parameter from a received spatial cue, i.e., CLD. The CLD includes level difference information of audio signals and it is expressed as:

$$CLD_m^i = 10\log_{10}\frac{P_m^k}{P_m^j}$$

<div align="right">Equation 1</div>

where $P_m^k$ denotes a sub-band power for a $k^{th}$ input audio signal in an $m^{th}$ sub-band.

The gain factor conversion unit 403 extracts power gain of each audio signal from the CLD parameter obtained in the CLD parsing unit 401.

Referring to Equation 1, when M audio signals are inputted in the $m^{th}$ sub-band, the number of CLDs that can be extracted in the $m^{th}$ sub-band is M-1 ($1 \le i \le$ M-1)). Therefore, the power gain of each audio signal is acquired from the CLD based on Equation 2 expressed as:

$$g_m^j = \frac{1}{\sqrt{1+10^{CLD_m^i/10}}} = \frac{\sqrt{P_m^j}}{\sqrt{P_m^k + P_m^j}}$$

$$g_m^k = g_m^j \cdot 10^{CLD_m^i/20} = \frac{\sqrt{P_m^j}}{\sqrt{P_m^k + P_m^j}}$$

<div align="right">Equation 2</div>

Therefore, power gain of the M input audio signal can be acquired from the M- 1 CLD in the $m^{th}$ sub- band.

Meanwhile, since the spatial cue is extracted on the basis of a sub- band of an input audio signal, power gain is extracted on the sub- band basis, too. When the power gains of all input audio signals in the $m^{th}$ sub- band are extracted, they can be expressed as a vector matrix shown in Equation 3:

$$G_m = \begin{bmatrix} g_m^1 \\ g_m^2 \\ \vdots \\ g_m^M \end{bmatrix}$$

<div align="right">Equation 3</div>

where m denotes a sub- band index;

$g_m^k$ denotes a sub-band power gain for a $k^{th}$ input audio signal ($1 \le k \le$ M) in the $m^{th}$ sub-band; and

$G_m$ denotes a vector indicating power gain of all input audio signals in the $m^{th}$ sub-band.

The power gain ($G_m$) of each audio signal extracted in the gain factor conversion unit is inputted into the gain factor control unit 405 and adjusted. The adjustment controls the rendering of the input audio signal and, eventually, forms a desired audio scene.

Rendering information inputted to the gain factor control unit 405 includes the number (N) of input audio signals, virtual position and level of each input audio signal including burst and suppression, and the number (M) of output audio signals, and virtual position information. The gain factor control unit 405 receives control information on the rendering of the input audio signals, which is audio scene information includes output position and output level of an input audio signal. The audio scene information is an interaction control signal inputted by a user outside. Then, the gain factor control unit 405 adjusts the power gain ($G_m$) of each input audio signal outputted from the gain factor conversion unit 403, and acquires a controlled power gain ($_{out}G_m$) as shown in Equation 4.

$$_{out}G_m = \begin{bmatrix} _{out}g_m^1 \\ _{out}g_m^2 \\ \vdots \\ _{out}g_m^M \end{bmatrix}$$

Equation 4

For example, when a suppression directing that the level for the first output audio signal $\left( _{out}g_m^1 \right)$ in the mth sub-band is inputted as rendering control information, the gain factor control unit 405 calculates a controlled power gain ($_{out}G_m$) based on the power gain ($G_m$) of each audio signal outputted from the gain factor conversion unit 403 as shown in Equation 5.

$$_{out}G_m = \begin{bmatrix} _{out}g_m^1 \\ _{out}g_m^2 \\ \vdots \\ _{out}g_m^M \end{bmatrix} = \begin{bmatrix} 0 \\ g_m^2 \\ \vdots \\ g_m^M \end{bmatrix}$$

Equation 5

When it is expressed more specifically, it equals to the following Equation 6.

$$_{out}G_m = \begin{bmatrix} _{out}g_m^1 \\ _{out}g_m^2 \\ \vdots \\ _{out}g_m^M \end{bmatrix} = \overbrace{\begin{bmatrix} 0 & 0 & \cdots & 0 \\ 0 & 1 & \cdots & 0 \\ \vdots & \vdots & \ddots & \vdots \\ 0 & 0 & \cdots & 1 \end{bmatrix}}^{M} \begin{bmatrix} g_m^1 \\ g_m^2 \\ \vdots \\ g_m^M \end{bmatrix}$$

Equation 6

In other words, the level of the first output audio signal ( $_{out}g_m^1$ ) in the $m^{th}$ sub-band can be eliminated by adjusting the factor of the first input audio signal ( $\overline{g}_m^1$ ) in the $m^{th}$ sub-band of a matrix to be 0. This is referred to as suppression.

Likewise, it is possible to burst the level of a particular output audio signal. After all, according to an embodiment of the present invention, the output level of an output audio signal can be controlled by changing the power gain value obtained based on a spatial cue.

As another embodiment of the present invention, when rendering information directing that the first input audio signal ( $g_m^1$ ) of the $m^{th}$ sub-band should be positioned between the first output audio signal ( $_{out}g_m^1$ ) and the second output audio signal ( $_{out}g_m^2$ ) of the $m^{th}$ sub-band (e.g., angle information on a plane, $\theta = 45°$) is inputted to the gain factor control unit 405, the gain factor control unit 405 calculates a controlled power gain ( $_{out}G_m$ ) based on the power gain ( $G_m$ ) of each audio signal outputted from the gain factor conversion unit 403 as shown in Equation 7.

$$_{out}G_m = \begin{bmatrix} _{out}g_m^1 \\ _{out}g_m^2 \\ \vdots \\ _{out}g_m^M \end{bmatrix} = \begin{bmatrix} g_m^1 \times \dfrac{1}{\sqrt{2}} \\ g_m^1 \times \dfrac{1}{\sqrt{2}} + g_m^2 \\ \vdots \\ g_m^M \end{bmatrix}$$

Equation 7

This can be specifically expressed as the following Equation 8.

$$_{out}G_m = \begin{bmatrix} _{out}g_m^1 \\ _{out}g_m^2 \\ \vdots \\ _{out}g_m^M \end{bmatrix} = \overbrace{\begin{bmatrix} \dfrac{1}{\sqrt{2}} & 0 & \cdots & 0 \\ \dfrac{1}{\sqrt{2}} & 1 & \cdots & 0 \\ \vdots & \vdots & \ddots & \vdots \\ 0 & 0 & \cdots & 1 \end{bmatrix}}^{M} \begin{bmatrix} g_m^1 \\ g_m^2 \\ \vdots \\ g_m^M \end{bmatrix}$$

Equation 8

A generalized embodiment of the method mapping an input audio signal between output audio signals is a mapping method adopting a Panning Law. Panning Law includes Sine Panning Law, Tangent Panning Law, and Constant Power Panning Law (CPP Law). Whatever the sort of the Panning Law is, what is to be achieved by the Panning Law is the same.

Hereinafter, a method of mapping an audio signal at a desired position based on the CPP in accordance with an embodiment of the present invention. However, the present invention is not limited only to the use of CPP, and it is obvious to those skilled in the art of the present invention that the present invention is not limited to the use of the CPP.

According to an embodiment of the present invention, all multi-object or multi-channel audio signals are panned based on the CPP for a given panning angle. Also, the CPP is not applied to an output audio signal but it is applied to power gain extracted from CLD values to utilize a spatial cue. After the CPP is applied, a controlled power gain of an audio signal is converted into CLD, which is transmitted to the SAC decoder 203 to thereby produce a panned multi-object or multi-channel audio signal.

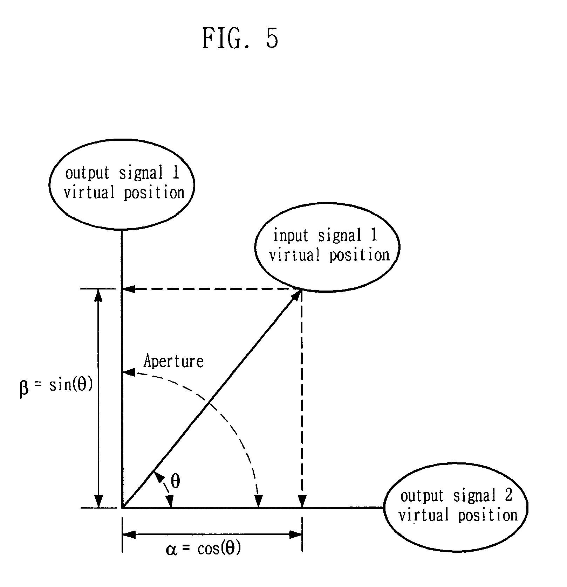

Fig. 5 illustrates a method of mapping audio signals to desired positions by utilizing CPP in accordance with an embodiment of the present invention. As illustrated in the drawing, the positions of output signals 1 and 2

$(\ _{out}g^1_m\ $ and $\ _{out}g^2_m\ )$ are 0° and 90°, respectively. Thus, an aperture is 90° in Fig. 5.

When the first input audio signal $(\ g^1_m\ )$ is positioned at θ between output signals 1 and 2 $(\ _{out}g^1_m\ $ and $_{out}g^2_m\ )$, α, β values are defined as α=cos (θ), β=sin (θ), respectively. According to the CPP Law, the position of an input audio signal is projected onto an axis of the output audio signal, and the α, β values are calculated by using sine and cosine functions. Then, a controlled power gain is obtained and the rendering of an audio signal is controlled. The controlled power gain ($_{out}G_m$) acquired based on the α, β values is expressed as Equation 9.

$$_{out}G_m = \begin{bmatrix} _{out}g^1_m \\ _{out}g^2_m \\ \vdots \\ _{out}g^M_m \end{bmatrix} = \begin{bmatrix} g^1_m \times \beta \\ g^1_m \times \alpha + g^2_m \\ \vdots \\ g^M_m \end{bmatrix} \qquad \text{Equation 9}$$

where α=cos (θ), β=sin (θ) .

The Equation 9 can be specifically expressed as the following Equation 10.

$$_{out}G_m = \begin{bmatrix} _{out}g^1_m \\ _{out}g^2_m \\ \vdots \\ _{out}g^M_m \end{bmatrix} = \overbrace{\begin{bmatrix} \beta & 0 & \cdots & 0 \\ \alpha & 1 & \cdots & 0 \\ \vdots & \vdots & \ddots & \vdots \\ 0 & 0 & \cdots & 1 \end{bmatrix}}^{M} \begin{bmatrix} g^1_m \\ g^2_m \\ \vdots \\ g^M_m \end{bmatrix} \qquad \text{Equation 10}$$

where the α,β values may be different according to a Panning Law applied thereto.

The α,β values are acquired by mapping the power gain of an input audio signal to a virtual position of an output audio signal so that they conform to predetermined apertures.

According to an embodiment of the present invention, rendering can be controlled to map an input audio signal to a desired position by controlling a spatial cue, such as power gain information of the input audio signal, in the spatial cue domain.

In the above, a case where the number of the power gains of input audio signals is the same as the number of the power gains of output audio signals has been described. When the number of the power gains of the input audio signals is different from the number of the power gains of the output audio signals, which is a general case, the dimension of the matrixes of the Equations 6, 8 and 1 is expressed not as M×M but as M×N.

For example, when the number of output audio signals is 4 (M=4) and the number of input audio signals is 5 (N=5) and when rendering control information (e.g., the position of input audio signal and the number of output audio signals) is inputted to the gain factor controller 405, the gain factor controller 405 calculates a controlled power gain ($_{out}G_m$) from the power gain ($G_m$) of each audio signal outputted from the gain factor conversion unit 403.

$$_{out}G_m = \begin{bmatrix} _{out}g_m^1 \\ _{out}g_m^2 \\ _{out}g_m^3 \\ _{out}g_m^4 \end{bmatrix} = \begin{bmatrix} \beta_1 & 0 & 0 & 0 & \alpha_5 \\ \alpha_1 & \beta_2 & 0 & \alpha_4 & 0 \\ 0 & 0 & \beta_3 & 0 & \beta_5 \\ 0 & \alpha_2 & \alpha_3 & \beta_4 & 0 \end{bmatrix} \begin{bmatrix} g_m^1 \\ g_m^2 \\ g_m^3 \\ g_m^4 \\ g_m^5 \end{bmatrix}$$

Equation 11

According to the Equation 11, N (N=5) input audio signals are mapped to M (M=4) output audio signals as follows. The first input audio signal ($g_m^1$) is mapped between output audio signals 1 and 2 ($_{out}g_m^1$ and $_{out}g_m^2$) based on the $\alpha_1, \beta_1$ values. The second input audio signal ($g_m^2$) is mapped between output audio signals 2 and 4 ($_{out}g_m^2$ and $_{out}g_m^4$) based on the $\alpha_2, \beta_2$ values. The third input audio signal ($g_m^3$) is mapped between output audio signals 3 and 4 ($_{out}g_m^3$ and $_{out}g_m^4$) based on $\alpha_3, \beta_3$ values. The fourth input audio signal ($g_m^4$) is mapped between output audio signals 2 and 4 ($_{out}g_m^2$ and $_{out}g_m^4$) based on $\alpha_4, \beta_4$ values. The fifth input audio signal ($g_m^5$) is mapped between output audio signals 1 and 3 ($_{out}g_m^1$ and $_{out}g_m^3$) based on $\alpha_5, \beta_5$ values.

In short, when the $\alpha$, $\beta$ values for mapping a $g_m^k$ value (where k is an index of an input audio signal, k=1, 2, 3, 4, 5) between predetermined output audio signals are defined as $\alpha_k, \beta_k$, N (N=5) input audio signals can be mapped to M (M=4) output audio signals. Hence, the input audio signals can be mapped to desired positions, regardless of the number of the output audio signals.

To make the output level of the $k^{th}$ input audio signal a 0 value, the $\alpha_k, \beta_k$ values are set 0, individually, which is suppression.

The controlled power gain ($_{out}G_m$) outputted from the gain factor controller 405 is converted into a CLD value in the CLD conversion unit 407. The CLD conversion unit 407 converts the controlled power gain ($_{out}G_m$) shown in the following Equation 12 into a converted CLD value, which is $CLD_m^i$, through calculation of common logarithm. Since the controlled power gain ($_{out}G_m$) is a power gain, 20 is multiplied.

$$converted\ CLD_m^i = 20\log_{10}\frac{_{out}g_m^k}{_{out}g_m^j}$$

Equation 12

where the $CLD_m^i$ value acquired in the CLD conversion unit 407 is acquired from a combination of factors of the control power gain ($_{out}G_m$), and a compared signal ($_{out}g_m^k$ or $_{out}g_m^j$) does not have to correspond to a signal ($P_m^k$ or $P_m^j$) for calculating the input CLD value. Acquisition of the converted CLD value ($CLD_m^i$) from M-1 combinations to express the controlled power gain ($_{out}G_m$) may be sufficient.

The converted signal ($CLD_m^i$) acquired in the CLD conversion unit 407 is inputted into the SAC decoder 203.

Hereinafter, the operations of the above-described gain factor conversion unit 403, gain factor control unit 405, and CLD conversion unit 407 will be described according to another embodiment of the present invention.

The gain factor conversion unit 403 extracts the power gain of an input audio signal from CLD parameters extracted in the CLD parsing unit 401. The CLD parameters are converted into gain coefficients of two input signals for each sub-band. For example, in case of a mono signal transmission mode called 5152 mode, the gain factor conversion unit 403 extracts power gains ($G_{0,l,m}^{Clfe}$ and $G_{0,l,m}^{LR}$) from the CLD parameters ($D_{CLD}^{Q}(ott,l,m)$) based on the following Equation 13. Herein, the 5152 mode is disclosed in detail in an International Standard MPEG Surround (WD N7136, 23003-1:2006/FDIS) published by the ISO/IEC JTC (International Organization for Standardization / International Electrotechnical Commission Joint Technical Committee) in February, 2005. Since the 5152 mode is no more than a mere embodiment for describing the present invention, detailed description on the 5152 mode will not be provided herein. The aforementioned International Standard occupies part of the present specification within a range that it contributes to the description of the present invention.

$$G_{0,l,m}^{Clfe} = \frac{1}{\sqrt{1+10^{D_{CLD}^{Q}(0,l,m)/10}}}$$

$$G_{0,l,m}^{LR} = G_{0,l,m}^{Clfe} \cdot 10^{\mathbf{D}_{CLD}^{Q}(0,l,m)/20} \qquad\qquad \text{Equation 13}$$

where m denotes an index of a sub-band;

1 denotes an index of a parameter set; and

Clfe and LR denote a summation of a center signal and an woofer (lfe) signal and a summation of a left plane signal (Ls + Lf) and a right plane signal (Rs + Rf), respectively.

According to an embodiment of the present invention, power gains of all input audio signals can be calculated based on the Equation 13.

Subsequently, the power gain ($pG$) of each sub- band can be calculated from multiplication of the power gain of the input audio signals based on the following Equation 14.

$$pG_{l,m}^{Lf} = G_{1,l,m}^{L} \cdot G_{3,l,m}^{Lf}$$

$$pG_{l,m}^{Ls} = G_{1,l,m}^{L} \cdot G_{3,l,m}^{Ls}$$

$$pG_{l,m}^{Rf} = G_{1,l,m}^{R} \cdot G_{4,l,m}^{Rf}$$

$$pG_{l,m}^{Rs} = G_{1,l,m}^{R} \cdot G_{4,l,m}^{Rs}$$

$$pG_{l,m}^{C} = G_{1,l,m}^{Clfe}, \quad pG_{l,m}^{lfe} = 0 \qquad (m>1)$$

$$pG_{l,m}^{lfe} = G_{1,l,m}^{Clfe} \cdot G_{2,l,m}^{lfe}, \quad pG_{l,m}^{C} = G_{1,l,m}^{Clfe} \cdot G_{2,l,m}^{C} \quad (m=0,1)$$

$$\text{Equation 14}$$

Subsequently, the channel gain ($pG$) of each audio signal extracted from the gain factor conversion unit 403 is inputted into the gain factor control unit 405 to be adjusted. Since rendering of the input audio signal is controlled through the adjustment, a desired audio scene can be formed eventually.

According to an embodiment, the CPP Law is applied to a pair of adjacent channel gains. First, a $\theta_m$ value is control information for rendering of an input audio signal and it is calculated from a given $\theta_{pan}$ value based on the following Equation 15.

$$\theta_m = \frac{(\theta_{pan} - \theta_1)}{(apeture - \theta_1)} \times \frac{\pi}{2}$$

$$\text{Equation 15}$$

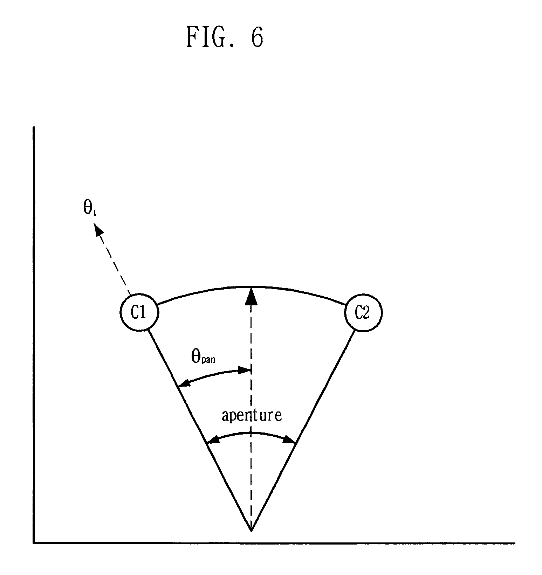

Herein, an aperture is an angle between two output signals and a $\theta_1$ value ($\theta_1=0$) is an angle of the position of a reference output signal. For example, Fig. 6 schematically shows a stereo layout including the relationship between the angles.

Therefore, a panning gain based on the control information ($\theta_{pan}$) for the rendering of an input audio signal is defined as the following Equation 16.

$$pG_{c1} = \cos(\theta_m)$$

$$pG_{c2} = \sin(\theta_m)$$

$$\text{Equation 16}$$

Of course, the aperture angle varies according to the angle between output signals. The aperture angle is 30° when the output signal is a front pair (C and Lf or C and Rf); 80° when the output signal is a side pair (Lf and Ls or Rf and Rs); and 140° when the output signal is a rear pair (Ls and Rs). For all input audio signals in each sub-band, controlled power gains (e.g., $_{out}G_m$ of the Equation 4) controlled based on the CPP Law are acquired according to the panning angle.

The controlled power gain outputted from the gain factor control unit 405 is converted into a CLD value in the CLD conversion unit 407. The CLD conversion unit 407 is converted into a $D_{CLD}^{\text{mod}ified}$ value, which is a CLD value, corresponding to the $CLD_m^i$ value, which is a converted CLD value, through calculation of common logarithm on the controlled power gain, which is expressed in the following Equation 17. The CLD value ( $D_{CLD}^{\text{mod}ified}$ ) is inputted into the SAC decoder 203.

$$\mathbf{D}_{CLD}^{\text{modfied}}(0, l, m) = 20 \log_{10}\left(\frac{pG_{Lf}(l,m)}{pG_{Ls}(l,m)}\right)$$

$$\mathbf{D}_{CLD}^{\text{modfied}}(1, l, m) = 20 \log_{10}\left(\frac{pG_{Rf}(l,m)}{pG_{Rs}(l,m)}\right)$$

$$\mathbf{D}_{CLD}^{\text{modfied}}(2, l, m) = 10 \log_{10}\left(\frac{pG_{Lf}^{2}(l,m) + pG_{Ls}^{2}(l,m)}{pG_{Rf}^{2}(l,m) + pG_{Rs}^{2}(l,m)}\right)$$

$$\mathbf{D}_{CLD}^{\text{modfied}}(3, l, m) = 20 \log_{10}\left(\frac{pG_{C}(l,m)}{pG_{lfe}(l,m)}\right)$$

$$\mathbf{D}_{CLD}^{\text{modfied}}(4, l, m) = 10 \log_{10}\left(\frac{pG_{Lf}^{2}(l,m) + pG_{Ls}^{2}(l,m) + pG_{Rf}^{2}(l,m) + pG_{Rs}^{2}(l,m)}{pG_{C}^{2}(l,m) + pG_{lfe}^{2}(l,m)}\right)$$

Equation 17

Hereinafter, a structure where CLD, CPC and ICC are used as spatial cues when the SAC decoder 203 is an MPEG Surround stereo mode, which is a so-called 525 mode. In the MPEG Surround stereo mode, a left signal L0 and a right signal R0 are received as input audio signals and a multi-channel signal is outputted as an output signal. The MPEG Surround stereo mode is disclosed in detail in International Standard MPEG Surround (WD N7136, 23003-1: 2006/FDIS) published by the ISO/IEC JTC in February 2005. In the present invention, the MPEG Surround stereo mode is no more than an embodiment for describing the present invention. Thus, detailed description on it will not be provided, and the International Standard forms part of the present specification within the range that it helps understanding of the present invention.

When the SAC decoder 203 is an MPEG Surround stereo mode, the SAC decoder 203, diagonal matrix elements of a vector needed for the SAC decoder 203 to generate multi-channel signals from the input audio signals L0 and R0 are fixed as 0, as shown in Equation 18. This signifies that the R0 signal does not contribute to the generation of Lf and Ls signals and the L0 signal does not contribute to the generation of Rf and Rs signals in the MPEG Surround stereo mode. Therefore, it is impossible to perform rendering onto audio signals based on the control information for the rendering of an input audio signal.

$$\mathbf{R}_1^{l,m} = \begin{bmatrix} w_{11}^{l,m} & 0 \\ 0 & w_{22}^{l,m} \\ w_{31}^{l,m}\sqrt{2} & w_{32}^{l,m}\sqrt{2} \\ w_{11}^{l,m} & 0 \\ 0 & w_{22}^{l,m} \end{bmatrix},$$

Equation 18

where $w_{ij}^{l,m}$ is a coefficient generated from a power gain acquired from CLD (i and j are vector matrix indexes; m is a sub-band index; and *l* is a parameter set index).

CLD for the MPEG Surround stereo mode includes $CLD_{LR/Clfe}$, $CLD_{L/R}$, $CLD_{C/lfe}$, $CLD_{Lf/Ls}$ and $CLD_{Rf/Rs}$. The $CLD_{Lf/Ls}$ is a sub- band power ratio (dB) between a left rear channel signal (Ls) and a left front channel signal (Lf), whereas $CLD_{Rf/Rs}$ is a sub- band power ratio (dB) between a right rear channel signal (Rs) and a right front channel signal (Rf) . The other CLD values are power ratios of a channel marked at their subscripts.

The SAC decoder 203 of the MPEG Surround stereo mode extracts a center signal (C), left half plane signals (Ls + Lf), and right half plane signals (Rf + Rs) from right and left signals (L0, RO) inputted based on the Equation 18. Each of the left half plane signals (Ls + Lf). The right half plane signals (Rf + Rs) and the left half plane signals (Ls + Lf) are used to generate right signal components (Rf, Rs) and left signal components (Ls, Lf), respectively.

It can be seen from the Equation 18 that the left half plane signals (Ls + Lf) is generated from the inputted left signal (L0). In short, right half plane signals (Rf + Rs) and the center signal (c) do not contribute to generation of the left signal components (Ls, Lf). The reverse is the same, too. (That is, the R0 signal does not contribute to generation of the Lf and Ls signals and, similarly, the L0 signal does not contribute to generation of the Rf and Rs signals.) This signifies that the panning angle is restricted to about $\pm30°$ for the rendering of audio signals.

According to an embodiment of the present invention, the above Equation 18 is modified as Equation 19 to flexibly control the rendering of multi-objects or multi-channel audio signals.

$$\mathbf{R}_1^{l,m} = \begin{bmatrix} w_{11}^{l,m} & w_{12}^{\prime l,m} \\ w_{21}^{\prime l,m} & w_{22}^{l,m} \\ w_{31}^{l,m}\sqrt{2} & w_{32}^{l,m}\sqrt{2} \\ w_{11}^{l,m} & w_{12}^{l,m} \\ w_{21}^{\prime l,m} & w_{22}^{l,m} \end{bmatrix}, \quad 0 \leq m < \mathbf{m}_{tttLowProc}(0), 0 \leq l < L$$

Equation 19

where $m_{tttLowProc}$ denotes the number of sub-bands.

Differently from Equation 18, Equation 19 signifies that the right half plane signals (Rf+Rs) and the center signal (C) contribute to the generation of the left signal components (Ls, Lf), and vice versa (which means that the R0 signal contributes to the generation of the Lf and Ls signals and, likewise, the L0 signal contributes to the generation of the Rf and Rs signals. This means that the panning angle is not restricted for the rendering of an audio signal.

The spatial cue renderer 201 shown in Figs. 2 and 4 outputs a controlled power gain ($_{out}G_m$) or a converted CLD value ( $CLD_m^i$ ) that is used to calculate a coefficient ( $w_{ij}^{l,m}$ ) which forms the vector of the Equation 19 based on the power gain of an input audio signal and control information for rendering of the input audio signal (i.e., an interaction control signal inputted from the outside). The elements $w_{12}^{\prime l,m}$ , $w_{21}^{\prime l,m}$ , $w_{31}^{\prime l,m}$ and $w_{32}^{\prime l,m}$ are defined as the

following Equation 20.

$$w_{12}'^{l,m} = \frac{P_{pan}^{L}}{\sqrt{P_C/2 + P_{Rf} + P_{Rs}}}$$

$$w_{21}'^{l,m} = \frac{P_{pan}^{R}}{\sqrt{P_C/2 + P_{Lf} + P_{Ls}}}$$

$$w_{13}'^{l,m} = \frac{P_{pan}^{CL}}{\sqrt{Pc/2 + P_{Rf} + P_{Rs}}}$$

$$w_{31}'^{l,m} = \frac{P_{pan}^{CR}}{\sqrt{P_C/2 + P_{Lf} + P_{Ls}}}$$

Equation 20

The functions of $w_{12}'^{l,m}$ and $w_{21}'^{l,m}$ are not extracting the center signal component (C) but projecting half plane signals onto the opposite half plane at the panning angle. The $w_{11}'^{l,m}$ and $w_{22}'^{l,m}$ are defined as the following Equation 21.

$$\left(w_{11}'^{l,m}\right)^2 + \left(w_{21}'^{l,m}\right)^2 + \left(w_{31}'^{l,m}\right)^2 = 1$$

$$\left(w_{12}'^{l,m}\right)^2 + \left(w_{22}'^{l,m}\right)^2 + \left(w_{32}'^{l,m}\right)^2 = 1$$

Equation 21

where the power gains ($P_C$, $P_{Lf}$, $P_{Ls}$, $P_{Rf}$, $P_{Rs}$) are calculated based on the CLD values ($CLD_{LR/Clfe}$, $CLD_{L/R}$, $CLD_{C/lfe}$, $CLD_{Lf/Ls}$ and $CLD_{Rf/Rs}$) inputted from the CLD parsing unit 401 based on the Equation 2.

$P_{pan}^{L}$ is a projected power according to the Panning Law in proportion to a combination of $P_C$, $P_{Lf}$, $P_{Ls}$. Similarly, $P_{pan}^{R}$ is in proportion to a combination of $P_C$, $P_{Rf}$, $P_{Rs}$. The $P_{pan}^{CL}$ and $P_{pan}^{CR}$ are panning power gains for the central channel of the left half plane and the central channel of the right half plane, respectively.

Equations 19 to 21 aim at flexibly controlling the rendering of the left signal (L0) and the right signal (R0) of input audio signals according to the control information, which is an interaction control signal. The gain factor control unit 405 receives the control information, which is an interaction control signal for rendering of an input audio signal, for example, angle information $\theta_{pan}$=40°. Then, it adjusts the power gains ($P_C$, $P_{Lf}$, $P_{Ls}$, $P_{Rf}$, $P_{Rs}$) of each input audio signal outputted from the gain factor conversion unit 403, and calculates additional power gains ($P_{pan}^{L}$, $P_{pan}^{R}$, $P_{pan}^{CL}$ and $P_{pan}^{CR}$) as shown in the following Equation 22.

$$P_{pan}^{CR} = P_C/2 + \alpha^2 \cdot P_{Lf} = P_C/2 + (\cos(\theta_m))^2 \cdot P_{Lf}$$

$$P_{pan}^{R} = \beta^2 \cdot P_{Lf} = (\sin(\theta_m))^2 \cdot P_{Lf}$$

$$P_{pan}^{CL} = P_C/2$$

$$P_{pan}^{L} = 0 \qquad\qquad\qquad \text{Equation 22}$$

where $\alpha = \cos(\theta_{pan})$, $\beta = \sin(\theta_{pan})$ ; and $\theta_m$ is as defined in Equation 15.

The acquired power gains $( \ P_C, P_{Lf}, P_{Ls}, P_{Rf}, P_{Rs} \ , \ P_{pan}^{L} \ , \ P_{pan}^{R} \ , \ P_{pan}^{CL} \ \text{and} \ P_{pan}^{CR} \ )$ are outputted as controlled power gains, which are presented in the following Equation 23.

$$_{out}g_m^{Lf} = 0$$

$$_{out}g_m^{Ls} = \sqrt{P_{Ls}}$$

$$_{out}g_m^{Rf} = \sqrt{P_{Rf} + P_{pan}^{R}}$$

$$_{out}g_m^{Rs} = \sqrt{P_{Rs}}$$

$$_{out}g_m^{CL} = \sqrt{P_C/2} = P_{pan}^{CL}$$

$$_{out}g_m^{CR} = \sqrt{P_{pan}^{CR}} \qquad\qquad \text{Equation 23}$$

Herein, the center signal (C) is calculated separately for CL and CR because the center signal should be calculated both from L0 and R0. In the MPEG Surround stereo mode, the gain factor control unit 405 outputs the controlled power gains of Equation 23, and the SAC decoder 203 performs rendering onto the input audio signals based on the control information on the rendering of the input audio signals, i.e., an interaction control signal, by applying the controlled power gains to the input audio signals L0 and R0 inputted based on the vector of the Equation 19.

Herein, the L0 and R0 should be pre- mixed or pre- processed to obtain the vector of the Equation 19 based on the matrix elements expressed as Equation 20 to control the rendering of the input audio signals L0 and R0 based on the vector of the Equation 19 in the SAC decoder 203. The pre- mixing or pre- processing makes it possible to control rendering of controlled power gains ($_{out}G_m$) or converted CLD value $( \ CLD_m^{i} \ )$ .

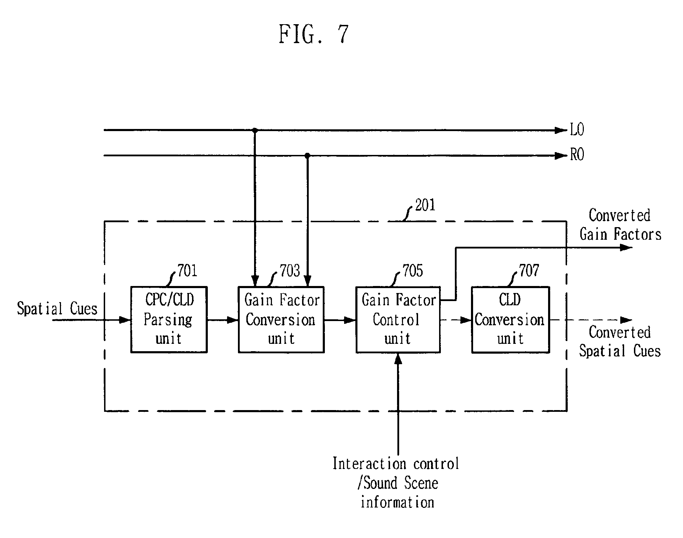

Fig. 7 is a detailed block diagram describing a spatial cue renderer 201 in accordance with an embodiment of the present invention, when the SAC decoder 203 is in the MPEG Surround stereo mode. As shown, the spatial cue renderer 201 using CLD or CPC as a spatial cue includes a CPC/CLD parsing unit 701, a gain factor conversion unit 703, a gain factor control unit 705, and a CLD conversion unit 707.

When the SAC decoder 203 uses CPC and CLD as spatial cues in the MPEG Surround stereo mode, the CPC makes a prediction based on some proper standards in an encoder to secure the quality of down-mixed signals and output signals for play. In consequences, CPC denotes a compressive gain ratio, and it is transferred to an audio signal rendering apparatus suggested in the embodiment of the present invention.

After all, lack of information on standard hinders accurate analysis on the CPC parameter in the spatial cue renderer 201. In other words, even if the spatial cue renderer 201 can control the power gains of audio signals, once the power gains of the audio signals are changed (which means 'controlled') according to control information (i.e., an interaction control signal) on rendering of the audio signals, no CPC value is calculated from the controlled power gains of the audio signals.

According to the embodiment of the present invention, the center signal (C), left half plane signals (Ls+Lf), and right half plane signals (Rs+Rf) are extracted from the input audio signals L0 and R0 through the CPC. The other audio signals, which include left signal components (Ls, Lf) and right signal components (Rf, Rs), are extracted through the CLD. The power gains of the extracted audio signals are calculated. Sound scenes are controlled not by directly manipulating the audio output signals but by controlling the spatial cue parameter so that the acquired power gains are changed (i.e., controlled) according to the control information on the rendering of the audio signals.

First, the CPC/CLD parsing unit 701 extracts a CPC parameter and a CLD parameter from received spatial cues (which are CPC and CLD). The gain factor conversion unit 703 extracts the center signal (C), left half plane signals (Ls + Lf) and right half plane signals (Rf + Rs) from the CPC parameter extracted in the CPC/CLD parsing unit 701 based on the following Equation 24.

$$M_{PDC}\begin{bmatrix} l_0 \\ r_0 \end{bmatrix} = \begin{bmatrix} l \\ r \\ c \end{bmatrix}$$

$$M_{PDC} = \begin{bmatrix} c_{11} & c_{12} \\ c_{21} & c_{22} \\ c_{31} & c_{32} \end{bmatrix}$$

Equation 24

where $l_0$, $r_0$, $l$, $r$, $c$ denote input the audio signals L0 and R0, the left half plane signal (Ls + Lf), the right half plane signal (Rf + Rs), and the center signal (C), respectively; and $M_{PDC}$ denotes a CPC coefficient vector.

The gain factor conversion unit 703 calculates the power gains of the center signal (C), the left half plane signal (Ls + Lf), and the right half plane signal (Rf + Rs), and it also calculates power gains of the other audio signals, which include the left signal components (Ls, Lf) and the right signal components (Rf, Rs), individually, from the CLD parameter ($CLD_{Lf/Ls}$, $CLD_{Rf/Rs}$) extracted in the CPC/CLD parsing unit 701, such as Equation 2. Accordingly, the power gains of the sub- bands are all acquired.

Subsequently, the gain factor control unit 705 receives the control information (i.e., an interaction control signal) on the rendering of the input audio signals, controls the power gains of the sub- bands acquired in the gain factor conversion unit 703 and calculates controlled power gains which are shown in the Equation 4.

The controlled power gains are applied to the input audio signals L0 and R0 through the vector of the Equation 19 in the SAC decoder 203 to thereby perform rendering according to the control information (i.e., an interaction control signal) on the rendering of the input audio signals.

Meanwhile, when the SAC decoder 203 is in the MPEG Surround stereo mode and it uses ICC as a spatial cue, the spatial cue renderer 201 corrects the ICC parameter through a linear interpolation process as shown in the following Equation 25.

$$ICC_{Ls,Lf} = (1-\eta)ICC_{Ls,Lf} + \eta ICC_{Rs,Rf}$$

$$ICC_{Rs,Rf} = (1-\eta)ICC_{Rs,Rf} + \eta ICC_{Ls,Lf}$$

$$\eta = \frac{\theta_{pan}}{\pi}, \qquad \theta_{pan} \leq \pi$$

$$\eta = 1 - \frac{\theta_{pan} - \pi}{\pi}, \qquad \theta_{pan} > \pi \qquad\qquad \text{Equation 25}$$

where $\theta_{pan}$ denotes angle information inputted as the control information (i.e., an interaction control signal) on the rendering of the input audio signal.

In short, the left and right ICC values are linearly interpolated according to the rotation angle ($\theta_{pan}$).

Meanwhile, a conventional SAC decoder receives a spatial cue, e.g., CLD, converts it into a power gain, and decodes an input audio signal based on the power gain.

Herein, the CLD inputted to the conventional SAC decoder corresponds to the converted signal value ($CLD_m^i$) of the CLD conversion unit 407 in the embodiment of the present invention. The power gain controlled by the conventional SAC decoder corresponds to the power gain ($_{out}G_m$) of the gain factor control unit 405 in the embodiment of the present invention.

According to another embodiment of the present invention, the SAC decoder 203 may use the power gain ($_{out}G_m$) acquired in the gain factor control unit 405 as a spatial cue, instead of using the converted signal value ($\overline{CLD}_m^i$) acquired in the CLD conversion unit 407. Hence, the process of converting the spatial cue, i.e., $\overline{CLD}_m^i$, into a power gain ($_{out}G_m$) in the SAC decoder 203 may be omitted. In this case, since the SAC decoder 203 does not need the converted signal value ($CLD_m^i$) acquired in the CLD conversion unit 407, the spatial cue renderer 201 may be designed not to include the CLD conversion unit 407.

Meanwhile, the functions of the blocks illustrated in the drawings of the present specification may be integrated into one unit. For example, the spatial cue renderer 201 may be formed to be included in the SAC decoder 203. Such integration among the constituent elements belongs to the scope and range of the present invention. Although the blocks illustrated separately in the drawings, it does mean that each block should be formed as a separate unit.

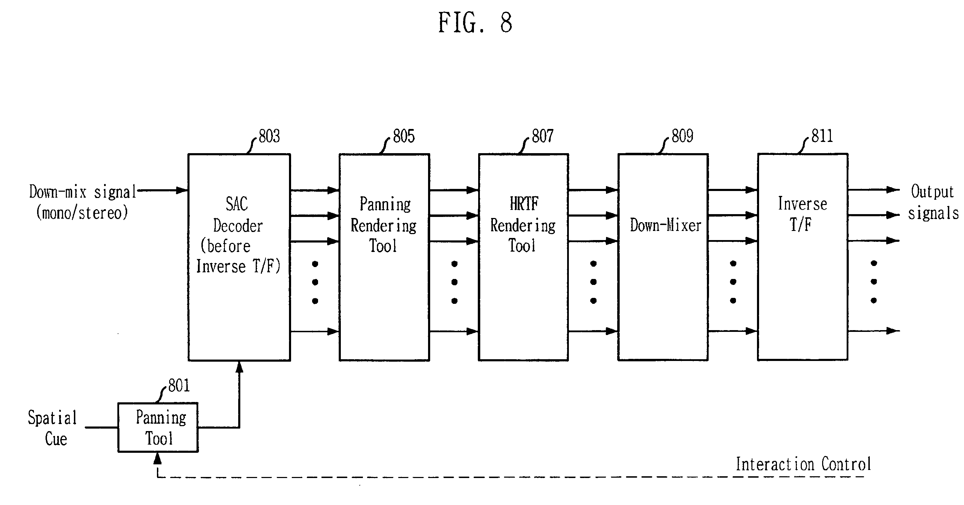

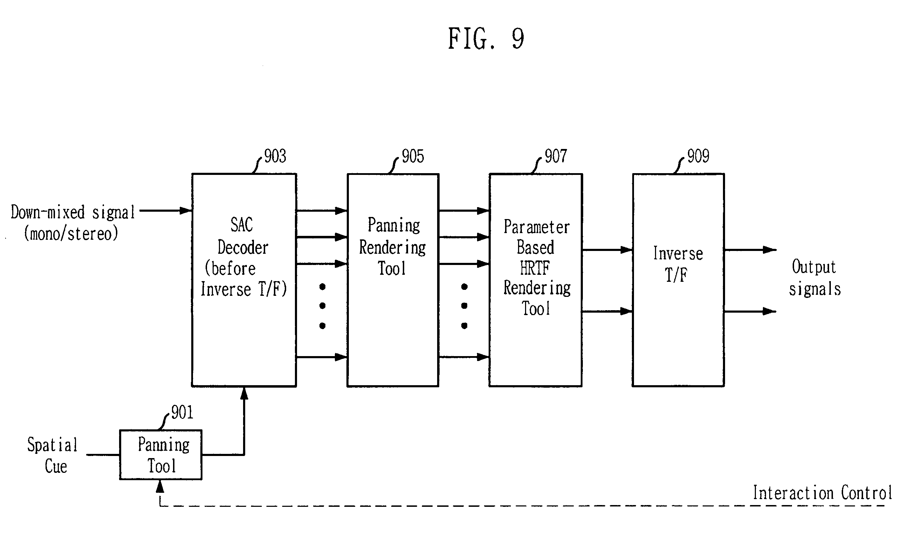

Figs. 8 and 9 present an embodiment of the present invention to which the audio signal rendering controller of Fig. 2 can be applied. Fig. 8 illustrates a spatial decoder for decoding multi-object or multi-channel audio signals. Fig. 9 illustrates a three-dimensional (3D) stereo audio signal decoder, which is a spatial decoder.

SAC decoders 803 and 903 of Figs. 8 and 9 may adopt an audio decoding method using a spatial cue, such as MPEG Surround, Binaural Cue Coding (BCC), and Sound Source Location Cue Coding (SSLCC). The panning tools 901 and 901 of Figs. 8 and 9 correspond to the spatial cue renderer 201 of Fig. 2.

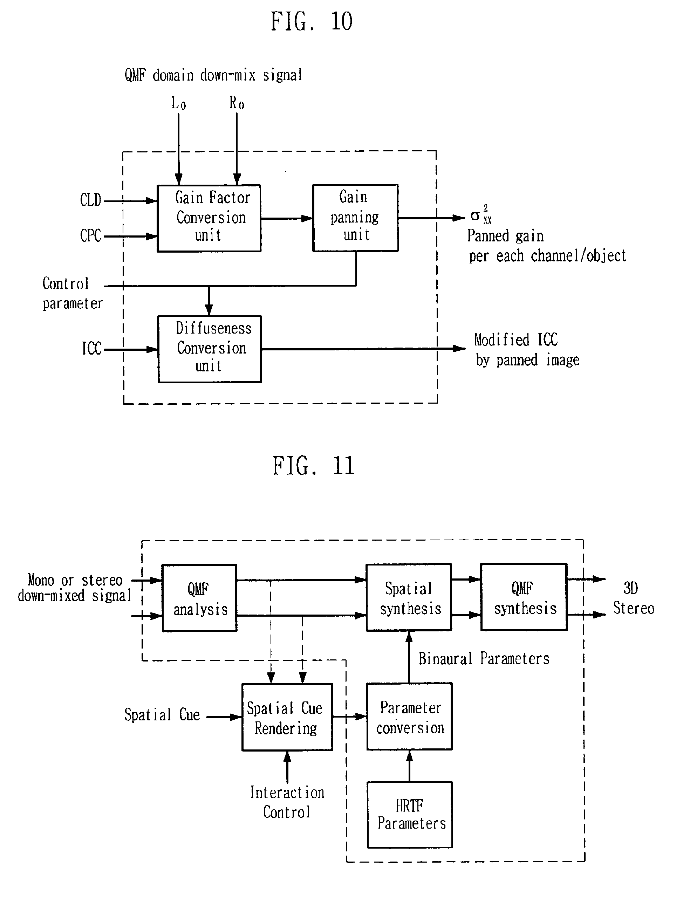

Fig. 10 is a view showing an example of the spatial cue renderer 201 of Fig. 2 that can be applied to Figs. 8 and 9.

Fig. 10 corresponds to the spatial cue renderer of Fig. 4. The spatial cue renderer shown in Fig. 10 is designed to process other spatial cues such as CPC and ICC, and the spatial cue renderer of Fig. 4 processes only CLD. Herein, the parsing unit and the CLD conversion unit are omitted for the sake of convenience, and the control information (i.e., an interaction control signal) on the rendering of input audio signals and the gain factor control unit are presented as a control parameter and a gain panning unit, respectively. The output ($\sigma_{xx}^2$) of the gain factor control unit signifies a controlled power gain, and it may be inputted to the spatial cue renderer 201. As described above, the present invention can control the rendering of input audio signals based on a spatial cue, e.g., CLD, inputted to the decoder. An embodiment thereof is shown in Fig. 10.

According to the embodiment of the spatial cue renderer illustrated in Fig. 10, the level of a multi-object or multi-channel audio signal may be eliminated (which is referred to as suppression). For example, when CLD is information on a power level ratio of a $j^{th}$ input audio signal and a $k^{th}$ input audio signal in an $m^{th}$ sub-band, the power gain ($g_m^j$)

of the $j^{th}$ input audio signal and the power gain ($g_m^k$) of the $k^{th}$ input audio signal are calculated based on the Equation 2.

Herein, when the power level of the $k^{th}$ input audio signal is to be eliminated, only the power gain ($g_m^k$) element of the $k^{th}$ input audio signal is adjusted as 0.

Back to Figs. 8 and 9, according to the embodiment of the present invention, the multi-object or multi-channel audio signal is rendered according to the Panning method based on the rendering information of the controlled input audio signal, which is inputted to the panning rendering tools 805 and 905 and controlled in the spatial cue domain by the panning tools 801 and 901. Herein, since the input audio signal inputted to the panning rendering tools 805 and 905 is processed in the frequency domain (a complex number domain), the rendering may be performed on a sub-band basis, too.

A signal outputted from the panning rendering tools 805 and 905 may be rendered in an HRTF method in HRTF rendering tools 807 and 907. The HRTF rendering is a method applying an HRTF filter to each object or each channel.

The rendering process may be optionally carried out by using the panning method of the panning rendering tools 805 and 905 and the HRTF method of the HRTF rendering tools 807 and 907. That is, the panning rendering tools 805 and 905 and the HRTF rendering tools 807 and 907 are the options. However, when all the panning rendering tools 805 and 905 and the HRTF rendering tools 807 and 907 are selected, the panning rendering tools 805 and 905 are executed prior to the HRTF rendering tools 807 and 907.

As described above, the panning rendering tools 805 and 905 and the HRTF rendering tools 807 and 907 may not use the converted signal ($CLD_m^i$) acquired in the CLD conversion unit 407 of the panning tools 801 and 901, but use the power gain ($_{out}G_m$) acquired in the gain factor control unit 405. In this case, the HRTF rendering tools 807 and 907 may adjust the HRTF coefficient by using power level of the input audio signals of each object or each channel. Herein, the panning tools 801 and 901 may be designed not to include the CLD conversion unit 407.

A down-mixer 809 performs down-mixing such that the number of the output audio signals is smaller than the number of decoded multi-object or multi-channel audio signals.

An inverse T/F 811 converts the rendered multi-object or multi-channel audio signals of a frequency domain into a time domain by performing inverse T/F conversion.

The spatial cue-based decoder illustrated in Fig. 9, e.g., the 3D stereo audio signal decoder, also includes the panning rendering tool 905 and the HRTF rendering tool 907. The HRTF rendering tool 907 follows the binaural decoding method of the MPEG Surround to output stereo signals. In short, a parameter-based HRTF filtering is applied.

Since the panning rendering tools 805 and 905 and the HRTF rendering tools 807 and 907 are widely known, detailed description on them will not be provided herein.

The binaural decoding method is a method of receiving input audio signals and outputting binaural stereo signals, which are 3D stereo signals. Generally, the HRTF filtering is used.

The present invention can be applied to a case where binaural stereo signals, which are 3D stereo signals, are played through the SAC multi-channel decoder. Generally, binaural stereo signals corresponding to a 5.1 channel are created based on the following Equation 26.

$$x_{Binaural\_L}(t) = x_{Lf}(t) * h_{-30,L}(t) + x_{Rf\_L}(t) * h_{30,L}(t) + x_{Ls\_L}(t) * h_{-110,L}(t) + x_{Rs\_L}(t) * h_{110,L}(t) + x_{C\_L}(t) * h_{0,L}(t)$$

$$x_{Binaural\_R}(t) = x_{Lf}(t) * h_{-30,R}(t) + x_{Rf\_L}(t) * h_{30,R}(t) + x_{Ls\_L}(t) * h_{-110,R}(t) + x_{Rs\_L}(t) * h_{110,R}(t) + x_{C\_L}(t) * h_{0,R}(t)$$

Equation 26

where x denotes an input audio signal; $h$ denotes an HRTF function; and $x_{Binaural}$ denotes an output audio signal, which is a binaural stereo signal (3D stereo signal).

To sum up, an HRTF function goes through complex integral for each input audio signal to thereby be down-mixed and produce a binaural stereo signal.

According to conventional methods, the HRTF function applied to each input audio signal should be converted into a function of a control position and then used to perform rendering onto a binaural stereo signal according to the control information (e.g., interaction control signal) on the rendering of an input audio signal. For example, when the control information (e.g., interaction control signal) on the rendering of an input audio signal for the virtual position of Lf is 40°, the Equation 26 is converted into the following Equation 27.

$$x_{Binaural\_L}(t) = x_{Lf}(t) * h_{40,L}(t) + x_{Rf\_L}(t) * h_{30,L}(t) + x_{Ls\_L}(t) * h_{-110,L}(t) + x_{Rs\_L}(t) * h_{110,L}(t) + x_{C\_L}(t) * h_{0,L}(t)$$

$$x_{Binaural\_R}(t) = x_{Lf}(t) * h_{40,R}(t) + x_{Rf\_L}(t) * h_{30,R}(t) + x_{Ls\_L}(t) * h_{-110,R}(t) + x_{Rs\_L}(t) * h_{110,R}(t) + x_{C\_L}(t) * h_{0,R}(t)$$

$$\text{Equation 27}$$

According to an embodiment of the present invention, however, a sound scene is controlled for an output audio signal by adjusting a spatial cue parameter based on the control information (e.g., an interaction control signal) on the rendering of an input audio signal, instead of controlling the HRTF function differently from the Equation 27 in a process of controlling rendering of a binaural stereo signal. Then, the binaural signal is rendered by applying only a predetermined HRTF function of the Equation 26.

When the spatial cue renderer 201 controls the rendering of a binaural signal based on the controlled spatial cue in the spatial cue domain, the Equation 26 can be always applied without controlling the HRTF function such as the Equation 27.

After all, the rendering of the output audio signal is controlled in the spatial cue domain according to the control information (e.g., an interaction control signal) on the rendering of an input audio signal in the spatial cue renderer 201. The HRTF function can be applied without a change.

According to an embodiment of the present invention, rendering of a binaural stereo signal is controlled with a limited number of HRTF functions. According to a conventional binaural decoding method, HRTF functions are needed as many as possible to control the rendering of a binaural stereo signal.

Fig. 11 is a view illustrating a Moving Picture Experts Group (MPEG) Surround decoder adopting a binoral stereo decoding. It shows a structure that is conceptually the same as that of Fig. 9. Herein, the spatial cue rendering block is a spatial cue renderer 201 and it outputs a controlled power gain. The other constituent elements are conceptually the same as those of Fig. 9, too, and they show a structure of an MPEG Surround decoder adopting a binaural stereo decoding. The output of the spatial cue rendering block is used to control the frequency response characteristic of the HRTF functions in the parameter conversion block of the MPEG Surround decoder.

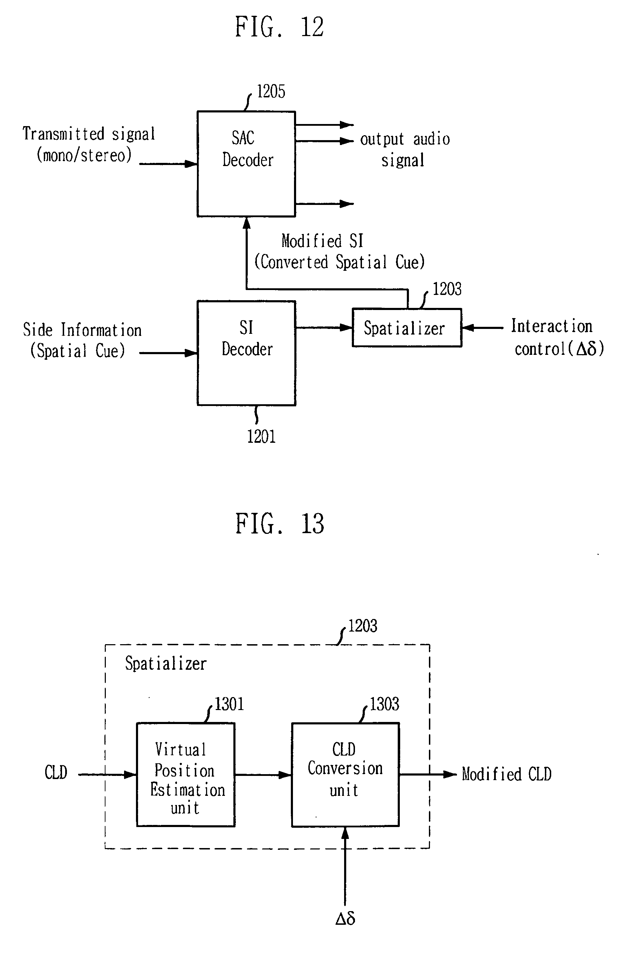

Figs. 12 to 14 present another embodiment of the present invention. Fig. 12 is a view describing an audio signal rendering controller in accordance with another embodiment of the present invention. According to the embodiment of the present invention, multi-channel audio signals can be efficiently controlled by adjusting a spatial cue, and this can be usefully applied to an interactive 3D audio/video service.

As shown in the drawings, the audio signal rendering controller suggested in the embodiment of the present invention includes an SAC decoder 1205, which corresponds to the SAC encoder 101 of Fig. 1, and it further includes a side information (SI) decoder 1201 and a spatializer 1203.

The side information decoder 1201 and the spatializer 1203 correspond to the spatial cue renderer 201 of Fig. 2. Particularly, the side information decoder 1201 corresponds to the CLD parsing unit 401 of Fig. 4.

The side information decoder 1201 receives a spatial cue, e.g., CLD, and extracts a CLD parameter based on the Equation 1. The extracted CLD parameter is inputted to the spatializer 1203.

Fig. 13 is a detailed block diagram illustrating a spatializer of Fig. 12. As shown in the drawing, the spatializer 1203 includes a virtual position estimation unit 1301 and a CLD conversion unit 1303.

The virtual position estimation unit 1301 and the CLD conversion unit 1303 functionally correspond to the gain factor conversion unit 403, the gain factor control unit 405, and the CLD conversion unit 407 of Fig. 4.

The virtual position estimation unit 1301 calculates a power gain of each audio signal based on the inputted CLD parameter. The power gain can be calculated in diverse methods according to a CLD calculation method. For example, when all CLD of an input audio signal is calculated based on a reference audio signal, the power gain of each input audio signal can be calculated as the following Equation 28.

$$G_{i,b} = \frac{1}{\sqrt{1 + \sum_{i=1}^{C-1} 10^{CLD_{i,b}/10}}}$$

$$G_{i+1,b} = 10^{CLD_{i+1,b}/10} G_{i,b}$$

Equation 28

where C denotes the number of the entire audio signals;

i denotes an audio signal index ($1 \leq i \leq C-1$) ;

b denotes a sub-band index; and

$G_{i,b}$ denotes a power gain of an input audio signal (which includes a left front channel signal Lf, a left rear channel signal Ls, a right front channel signal Rf, a right rear channel signal Rs, and a center signal C) .

Generally, the number of sub-bands is between 20 and 40 per frame. When the power gain of each audio signal is calculated for each sub-band, the virtual position estimation unit 1301 estimates the position of a virtual sound source from the power gain.

For example, when the input audio signals are of five channels, the spatial vector (which is the position of the virtual sound source) may be estimated as the following Equation 29.

$$Gv_b = A_1 \times G_{1,b} + A_2 \times G_{2,b} + A_3 \times G_{3,b} + A_4 \times G_{4,b} + A_5 \times G_{5,b}$$

$$LHv_b = A_1 \times G_{1,b} + A_2 \times G_{2,b} + A_4 \times G_{4,b}$$

$$RHv_b = A_1 \times G_{1,b} + A_3 \times G_{3,b} + A_5 \times G_{5,b}$$

$$Lsv_b = A_1 \times G_{1,b} + A_2 \times G_{2,b}$$

$$Rsv_b = A_1 \times G_{1,b} + A_3 \times G_{3,b}$$

Equation 29

where i denotes an audio signal index; b denotes a sub-band index;

$A_i$ denotes the position of an output audio signal, which is a coordinate represented in a complex plane;

$Gv_b$ denotes an all-directional vector considering five input audio signals Lf, Ls, Rf, Rs, and C;

$LHv_b$ denotes a left half plane vector considering the audio signals Lf, Ls and C on a left half plane;

$RHv_b$ denotes a right half plane vector considering the audio signals Rf, Rs and C on a right half plane;

$Lsv_b$ denotes a left front vector considering only two input audio signals Lf and C; and

$Rsv_b$ denotes a right front vector considering only two input audio signals Rf and C.

Herein, $Gv_b$ is controlled to control the position of a virtual sound source. When the position of a virtual sound source is to be controlled by using two vectors, $LHv_b$ and $RHv_b$ are utilized. The position of the virtual sound source is to be controlled with vectors for two pairs of input audio signals (i.e., a left front vector and a right front vector) such

vectors as $\mathbf{Lsv_b}$ and $\mathbf{Rsv_b}$ may be used. When a vector is acquired and utilized for two pairs of input audio signals, there may be audio signal pairs as many as the number of input audio signals.

Information on the angle (i.e., panning angle of a virtual sound source) of each vector is calculated based on the following Equation 30.

$$ Ga_b = \angle(Gv_b) = \arctan \frac{\mathrm{Im}(Gv_b)}{\mathrm{Re}(Gv_b)} $$

Equation 30

Similarly, angle information ($\mathbf{LHa_b}$, $\mathbf{RHa_b}$, $\mathbf{Lsa_b}$ and $\mathbf{Rsa_b}$) of the rest vectors may be acquired similarly to the Equation 20.

The panning angle of a virtual sound source can be freely estimated among desired audio signals, and the Equations 29 and 30 are no more than mere part of diverse calculation methods. Therefore, the present invention is not limited to the use of Equations 29 and 30.

The power gain ($\mathbf{M_{downmix,b}}$) of a b$^{th}$ sub-band of a down-mixed signal is calculated based on the following Equation 31.

$$ M_{downmix,b} = \sqrt{\sum_{n=B_b}^{B_{b+1}-1} \left| S_{downmix}(n) \right|} $$

Equation 31

where b denotes an index of a sub-band;

$B_b$ denotes a boundary of a sub-band;

S denotes a down-mixed signal; and

n denotes an index of a frequency coefficient.

The spatializer 1203 is a constituent element that can flexibly control the position of a virtual sound source generated in the multiple channels. As described above, the virtual position estimation unit 1301 estimates a position vector of a virtual sound source based on the CLD parameter. The CLD conversion unit 1303 receives a position vector of the virtual sound source estimated in the virtual position estimation unit 1301 and a delta amount ($\Delta\delta$) of the virtual sound source as rendering information, and calculates a position vector of a controlled virtual sound source based on the following Equation 32.

$$ \overline{Ga_b} = Ga_b + \Delta\delta $$

$$ \overline{LHa_b} = LHa_b + \Delta\delta $$

$$\overline{RHa_b} = RHa_b + \Delta\delta$$

$$\overline{Rsa_b} = Rsa_b + \Delta\delta$$

$$\overline{Lsa_b} = Lsa_b + \Delta\delta$$

The CLD conversion unit 1303 calculates controlled power gains of audio signals by reversely applying the Equations 29 and 31 to the position vectors ($\overline{Ga_b}$, $\overline{LHa_b}$, $\overline{RHa_b}$, $\overline{Rsa_b}$, and $\overline{Lsa_b}$) of the controlled virtual sound sources calculated based on the Equation 23. For example, an equation on $\overline{Ga_b}$ of the Equation 32 is applied for control with only one angle, and equations on $\overline{LHa_b}$ and $\overline{RHa_b}$ of the Equation 32 are applied for control with angles of two left half plane vector and a right half plane vector. Equations $\overline{Rsa_b}$ and $\overline{Lsa_b}$ of the Equation 32 are applied for control at an angle of a vector for two pairs of input audio signals (which include a left front audio signal and a right front audio signal). Equations on $Lsv_b$ and $Rsv_b$ are of the Equation 29 and equations $\overline{Rsa_b}$ and $\overline{Lsa_b}$ of the Equation 32 are similarly applied for control with an angle of a vector for the other pairs of input audio signals such as Ls and Lf, or Rs and Rf.

Also, the CLD conversion unit 1303 converts the controlled power gain into a CLD value.

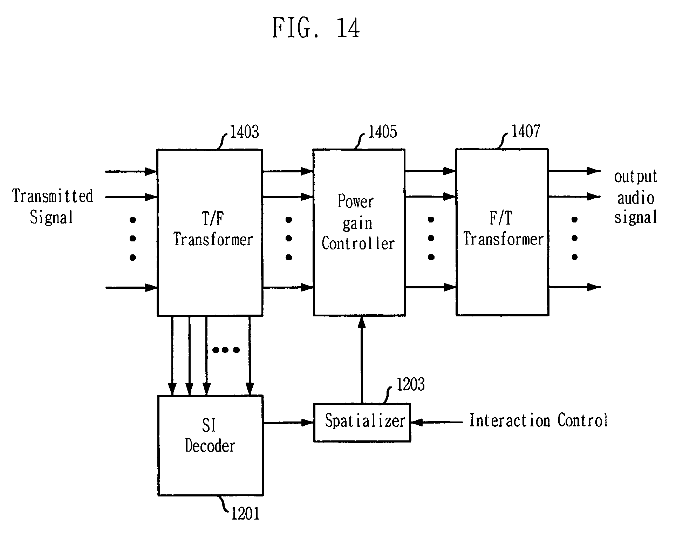

The acquired CLD value is inputted into the SAC decoder 1205. The embodiment of the present invention can be applied to general multi-channel audio signals. Fig. 14 is a view describing a multi-channel audio decoder to which an embodiment of the present invention is applied. Referring to the drawing, it further includes a side information decoder 1201 and a spatializer 1203.

Multi- channel signals of the time domain are converted into signals of the frequency domain in a transformer 1403, such as a Discrete Fourier Transform (DFT) unit or a Quadrature Mirror Filterbank Transform (QMFT).

The side information decoder 1201 extracts spatial cues, e.g., CLD, from converted signals obtained in the transformer 1403 and transmits the spatial cues to the spatializer 1203. The spatializer 1203 transmits the CLD indicating a controlled power gain calculated based on the position vector of a controlled virtual sound source, which is the CLD acquired based on the Equation 32, to the power gain controller 1405. The power gain controller 1405 controls the power of each audio channel for each sub-band in the frequency domain based on the received CLD. The controlling is as shown in the following Equation 33.

$$S'_{ch,n} = S_{ch,n} \times G_{i,b}^{\mathrm{mod}\mathit{ified\,CLD}}, \qquad B_n \leq n \leq B_{n+1} - 1$$

where $S_{ch,n}$ denotes an nth frequency coefficient of a ch$^{th}$ channel;

$S'_{ch,n}$ denotes a frequency coefficient deformed in the power gain control unit 1105;

$B_n$ denotes a boundary information of a b$^{th}$ sub-band; and

$G_{i,b}^{\mathrm{mod}\mathit{ified\,CLD}}$ denotes a gain coefficient calculated from a CLD value, which is an output signal of the spatializer 1203, i.e., a CLD value reflecting the Equation 32.

According to the embodiment of the present invention, the position of a virtual sound source of audio signals may be controlled by reflecting a delta amount of a spatial cue to the generation of multi-channel signals.

Although the above description has been made in the respect of an apparatus, it is obvious to those skilled in the art to which the present invention pertains that the present invention can also be realized in the respect of a method.

The method of the present invention described above may be realized as a program and stored in a computer-readable recording medium such as CD-ROM, RAM, ROM, floppy disks, hard disks, and magneto-optical disks.

While the present invention has been described with respect to certain preferred embodiments, it will be apparent to those skilled in the art that various changes and modifications may be made without departing from the scope of the invention as defined in the following claims.

**Industrial Applicability**

The present invention is applied to decoding of multi-object or multi-channel audio signals.

**Claims**

1.  An apparatus for controlling rendering of audio signals, comprising:

    a decoding means (203) for decoding an input audio signal, which is a down-mixed signal that is encoded in a Spatial Audio Coding (SAC) method, by using an SAC decoding method; and
    a spatial cue rendering means (201) for receiving spatial cue information and control information on rendering of the input audio signal and controlling the spatial cue information in a spatial cue domain based on the control information,
    wherein the decoding means performs rendering of the input audio signals based on a controlled spatial cue information controlled by the spatial cue rendering means,
    whereby the spatial cue information is a Channel Level Difference (CLD) indicating a level different among input audio signals, and
    wherein the spatial cue rendering means includes:

    a CLD parsing unit (401) for extracting a CLD parameter from the CLD transmitted from an encoding means;
    a gain factor conversion unit (403) for extracting a power gain of each audio signal from the CLD parameter extracted in the CLD parsing unit; and
    a gain factor control unit (405) for calculating a controlled power gain by controlling the power gain of each audio signal extracted in the gain factor conversion unit based on the control information on the rendering of the input audio signals; and
    a CLD conversion unit (407) for converting the controlled power gain outputted from the gain factor control unit into a CLD value, wherein
    the decoding means uses the CLD value acquired from the conversion in the CLD conversion unit as the controlled spatial information which is needed to perform the rendering of the input audio signal.

2.  The apparatus of claim 1, wherein the spatial cue information is expressed as Equation 1, and the Equation 1 being expressed as:

$$CLD_m^i = 10\log_{10}\frac{P_m^k}{P_m^j}$$

Equation 1

    where i denotes an index of CLD ($1 \leq i \leq N-1$) ;
    N denotes the number of input audio signals in an $m^{th}$ sub-band; and

    $P_m^k$ denotes a sub-band power for a $k^{th}$ input audio signal in an $m^{th}$ sub-band.

3.  The apparatus of claim 2, wherein the gain factor conversion unit extracts a power gain ($G_m$) of the input audio signal, which is expressed as Equation 2:

$$G_m = \begin{bmatrix} g_m^1 \\ g_m^2 \\ \cdots \\ g_m^k \\ \cdots \\ g_m^N \end{bmatrix}$$

$$g_m^j = \frac{1}{\sqrt{1 + 10^{CLD_m^i/10}}} = \frac{\sqrt{P_m^j}}{\sqrt{P_m^k + P_m^j}}$$

$$g_m^k = g_m^j \cdot 10^{CLD_m^i/20} = \frac{\sqrt{P_m^j}}{\sqrt{P_m^k + P_m^j}}$$

Equation 2

where m denotes an index of a sub-band;

$g_m^k$ denotes a sub-band power gain of a $k^{th}$ input audio signal (1≤k≤N) in an $m^{th}$ sub-band; and

$G_m$ denotes a power gain of all input audio signals in the $m^{th}$ sub-band.

4. The apparatus of claim 3, wherein the gain factor control unit calculates a controlled power gain ($_{out}G_m$) expressed as Equation 3 by controlling the power gain ($G_m$) of the input audio signal extracted in the gain factor conversion unit based on the control information on the rendering of the input audio signal according to a panning law, the Equation 3 being expressed as:

$$_{out}G_m = \begin{bmatrix} _{out}g_m^1 \\ _{out}g_m^2 \\ \vdots \\ _{out}g_m^M \end{bmatrix} = [\alpha, \beta]_{M \times N} \, G_m$$

Equation 3

where M denotes the number of output audio signals;

N denotes the number of input audio signals; and

$[\alpha, \beta]_{M \times N}$ denotes a M $\times$ N vector composed of coefficients $\alpha_k$ and $\beta_k$ that are calculated to map the input audio signal ( $g_m^k$ ) to a position between arbitrary output audio signals.

5. An apparatus according to claim 1,
wherein the decoding means performs rendering of the input audio signal based on spatial cue information controlled by the spatial cue rendering means, and
the spatial cue information is a Channel Level Difference (CLD) value representing a level difference between input audio signals and expressed as $D_{CLD}^{Q}(ott, l, m)$, and

m denoting an index of a sub-band and 1 denoting an index of a parameter set in the $D_{CLD}^{Q}(ott, l, m)$.

6. The apparatus of claim 5, wherein the gain factor conversion unit extracts the power gain ($G_m$) of the input audio signal that is expressed as Equation 5:

$$G_m = \begin{bmatrix} pG_{l,m}^{Lf} \\ pG_{l,m}^{Ls} \\ pG_{l,m}^{Rf} \\ pG_{l,m}^{Rs} \\ pG_{l,m}^{C} \\ pG_{l,m}^{lfe} \end{bmatrix}$$

$$pG_{l,m}^{Lf} = G_{1,l,m}^{L} \cdot G_{3,l,m}^{Lf}$$

$$pG_{l,m}^{Ls} = G_{1,l,m}^{L} \cdot G_{3,l,m}^{Ls}$$

$$pG_{l,m}^{Rf} = G_{1,l,m}^{R} \cdot G_{4,l,m}^{Rf}$$

$$pG_{l,m}^{Rs} = G_{1,l,m}^{R} \cdot G_{4,l,m}^{Rs}$$

$$pG_{l,m}^{C} = G_{1,l,m}^{Clfe}, \quad pG_{l,m}^{lfe} = 0 \qquad (m>1)$$

$$pG_{l,m}^{lfe} = G_{1,l,m}^{Clfe} \cdot G_{2,l,m}^{lfe}, \quad pG_{l,m}^{C} = G_{1,l,m}^{Clfe} \cdot G_{2,l,m}^{C} \quad (m=0,1)$$

$$G_{0,l,m}^{Clfe} = \frac{1}{\sqrt{1+10^{D_{CLD}^{Q}(0,l,m)/10}}}$$

$$G_{0,l,m}^{LR} = G_{0,l,m}^{Clfe} \cdot 10^{\mathbf{D}_{CLD}^{Q}(0,l,m)/20}$$

<div align="right">Equation 5</div>

where a coefficient of $G_m$ is a vector representing a power gain of an $m^{th}$ sub-band; and $G_m$ is a vector representing a power gain of all input audio signals in the $m^{th}$ sub-band.

7. The apparatus of claim 6, wherein the gain factor control unit calculates a controlled power gain ($_{out}G_m$) expressed as Equation 6 by controlling the power gain ($G_m$) of the input audio signal extracted in the gain factor conversion unit based on the control information on the rendering of the input audio signal according to a panning law, the Equation 6 being expressed as:

$$_{out}G_m = \begin{bmatrix} _{out}g_m^1 \\ _{out}g_m^2 \\ \vdots \\ _{out}g_m^M \end{bmatrix} = [\alpha,\beta]_{M \times N} \, G_m$$

<div align="right">Equation 6</div>

where M denotes the number of output audio signals;

N denotes the number of input audio signals; and

$[\alpha, \beta]_{M \times N}$ denotes a M × N vector composed of coefficients $\alpha_k$ and $\beta_k$ that are calculated to map the input audio signal to a position between arbitrary output audio signals.

8. The apparatus of claim 7, wherein the panning law is a Constant Power Panning (CPP) Law, and the coefficients $\alpha_k$ and $\beta_k$ are expressed as Equation 7:

$$\alpha_k = \cos(\theta_m), \beta_k = \sin(\theta_m)$$

$$\theta_m = \frac{\theta_{pan,k} - \theta_{ref}}{apertuer - \theta_{ref}} \times \frac{\pi}{2}$$

Equation 7

where $\theta_{pan,k}$ denotes angle information between the output audio signals to which the input audio signal ( $p\tilde{G}_{l,m}^{k}$ ) is mapped;

*apertuer* denotes angle information between the output audio signals; and

$\theta_{ref}$ denotes angle information of a reference output audio signal between the output audio signals.

9. The apparatus of claim 5, wherein the CLD conversion unit converts the controlled power gain into the CLD value based on Equation 8 expressed as:

$$\mathbf{D}_{CLD}^{modfied}(0, l, m) = 20 \log_{10} \left( \frac{pG_{Lf}(l,m)}{pG_{Ls}(l,m)} \right)$$

$$\mathbf{D}_{CLD}^{modfied}(1, l, m) = 20 \log_{10} \left( \frac{pG_{Rf}(l,m)}{pG_{Rs}(l,m)} \right)$$

$$\mathbf{D}_{CLD}^{modfied}(2, l, m) = 10 \log_{10} \left( \frac{pG_{Lf}^{2}(l,m) + pG_{Ls}^{2}(l,m)}{pG_{Rf}^{2}(l,m) + pG_{Rs}^{2}(l,m)} \right)$$

$$\mathbf{D}_{CLD}^{modfied}(3, l, m) = 20 \log_{10} \left( \frac{pG_{C}(l,m)}{pG_{lfe}(l,m)} \right)$$

$$\mathbf{D}_{CLD}^{modfied}(4, l, m) = 10 \log_{10} \left( \frac{pG_{Lf}^{2}(l,m) + pG_{Ls}^{2}(l,m) + pG_{Rf}^{2}(l,m) + pG_{Rs}^{2}(l,m)}{pG_{C}^{2}(l,m) + pG_{lfe}^{2}(l,m)} \right)$$

Equation 8

10. An apparatus according to claim 1,
wherein a center signal (C), a left half plane signal (Lf+Ls) and a right half plane signal (Rf+Rs) are extracted from the down- mixed signals L0 and R0 based on Equation 9, and

the spatial cue information is a Channel Level Difference (CLD) value representing a level difference between input audio signals and expressed as $CLD_{LR/Clfe}$, $CLD_{L/R}$, $CLD_{C/lfe}$, $CLD_{Lf/Ls}$ and $CLD_{Rf/Rs}$, and

the Equation 9 being expressed as:

$$\mathbf{R}_1''^{l,m} = \begin{bmatrix} w_{11}'^{l,m} & w_{12}''^{l,m} \\ w_{21}''^{l,m} & w_{22}'^{l,m} \\ w_{31}'^{l,m}\sqrt{2} & w_{32}'^{l,m}\sqrt{2} \\ w_{11}'^{l,m} & w_{12}'^{l,m} \\ w_{21}''^{l,m} & w_{22}'^{l,m} \end{bmatrix}, \quad 0 \le m < \mathbf{m}_{tttLowProc}(0), 0 \le l < L$$

$$w_{12}''^{l,m} = \frac{P_{pan}^L}{\sqrt{P_C/2 + P_{Rf} + P_{Rs}}}$$

$$w_{21}''^{l,m} = \frac{P_{pan}^R}{\sqrt{P_C/2 + P_{Lf} + P_{Ls}}}$$

$$w_{13}'^{l,m} = \frac{P_{pan}^{CL}}{\sqrt{Pc/2 + P_{Rf} + P_{Rs}}}$$

$$w_{31}''^{l,m} = \frac{P_{pan}^{CR}}{\sqrt{P_C/2 + P_{Lf} + P_{Ls}}}$$

$$\left(w_{11}'^{l,m}\right)^2 + \left(w_{21}'^{l,m}\right)^2 + \left(w_{31}'^{l,m}\right)^2 = 1$$

$$\left(w_{12}'^{l,m}\right)^2 + \left(w_{22}'^{l,m}\right)^2 + \left(w_{32}'^{l,m}\right)^2 = 1$$

Equation 9

where $w_{ij}^{l,m}$ is a coefficient generated from a power gain calculated based on the CLD values ($CLD_{LR/Clfe}$, $CLD_{L/R}$, $CLD_{C/lfe}$, $CLD_{Lf/Ls}$ and $CLD_{Rf/Rs}$) (i and j are indexes of vector matrixes; m is an index of a sub- band; and l is an index of a parameter set) ;

$m_{tttLowProc}$ is the number of sub- bands;

$P_C$, $P_{Lf}$, $P_{Ls}$, $P_{Rf}$, $P_{Rs}$, are power gains of a center signal, a left front signal, a left rear signal, a right front signal, and a right rear signal;

$P_{pan}^L$ denotes a projected power based on a panning law in proportion to a combination of $P_C$, $P_{Lf}$, $P_{Ls}$ ;

$P_{pan}^{\bar{R}}$ denotes a projected power based on a panning law in proportion to a combination of $P_C$, $P_{Rf}$, $P_{Rs}$ ; and

$P_{pan}^{CL}$ and $P_{pan}^{CR}$ are panning power gains for a left half plane and a right half plane with respect to a center channel, respectively.

11. The apparatus of claim 10, wherein the gain factor conversion unit extracts power gains ($P_C$, $P_{Lf}$, $P_{Ls}$, $P_{Rf}$, $P_{Rs}$) of the input audio signals based on CLD values ($CLD_{LR/Clfe}$, $CLD_{L/R}$, $CLD_{C/lfe}$, $CLD_{Lf/Ls}$ and $CLD_{Rf/Rs}$) .

**12.** The apparatus of claim 11, wherein the gain factor control unit additionally calculates the power gains ( $P_{pan}^{L}$ , $P_{pan}^{R}$ , $P_{pan}^{CL}$ and $P_{pan}^{CR}$ ) by controlling the power gains ($P_C$, $P_{Lf}$, $P_{Ls}$, $P_{Rf}$, $P_{Rs}$) of the input audio signals extracted in the gain factor conversion unit based on control information on rendering of the input audio signals, and

controlled power gains are calculated based on the obtained power gain ( $P_C, \breve{P}_{Lf}, P_{Ls}, P_{Rf}, P_{Rs}$ , $P_{pan}^{L}$ , $P_{pan}^{R}$ , $P_{pan}^{CL}$ and $P_{pan}^{CR}$ ).

**13.** The apparatus of claim 12, wherein the controlled power gains are calculated based on Equation 10 expressed as:

$$_{out}g_m^{Lf} = \sqrt{P_{Lf} + P_{pan}^{L}}$$

$$_{out}g_m^{Ls} = \sqrt{P_{Ls}}$$

$$_{out}g_m^{Rf} = \sqrt{P_{Rf} + P_{pan}^{R}}$$

$$_{out}g_m^{Rs} = \sqrt{P_{Rs}}$$

$$_{out}g_m^{CL} = \sqrt{P_C / 2}$$

$$_{out}g_m^{CR} = \sqrt{P_C / 2}$$

Equation 10

**14.** An apparatus for controlling rendering of audio signals, comprising:

a decoding means (201) for decoding an input audio signal, which is a down-mixed signal that is encoded in a Spatial Audio Coding (SAC) method, by using an SAC decoding method; and
a spatial cue rendering means (203) for receiving spatial cue information and control information on rendering of the input audio signal and controlling the spatial cue information in a spatial cue domain based on the control information,
wherein the decoding means performs rendering of the input audio signals based on a controlled spatial cue information controlled by the spatial cue rendering means,
wherein the spatial cue information is a Channel Level Difference (CLD) value representing a level difference between input audio signals and a Channel Prediction Coefficient (CPC) representing a down-mixing ratio of input audio signals,
and
the spatial cue rendering means includes:

a CPC/CLD parsing unit (701) for extracting a CPC parameter and a CLD parameter from a CPC and a CLD transmitted from an encoding means;
a gain factor conversion unit (703) for extracting power gains of each signal by extracting a center signal, a left half plane signal, and a right half plane signal from the CPC parameter extracted in the CPC/CLD parsing unit, and extracting power gains of left signal components and right signal components from the CLD parameter; and
a gain factor control unit (705) for calculating a controlled power gain by controlling a power gain of each audio signal extracted in the gain factor conversion unit based on control information on rendering of the input audio signal,
a CLD conversion unit (707) for converting the controlled power gain outputted from the gain factor control unit into a CLD value, wherein
the decoding means uses the CLD value acquired from the conversion in the CLD conversion unit as the controlled spatial information which is needed to perform the rendering of the input audio signal.

15. The apparatus of claim 14, wherein the gain factor conversion unit extracts a center signal, a left half plane signal, and a right half plane signal from the CPC parameter extracted in the CPC/CLD parsing unit based on Equation 11 expressed as:

$$M_{PDC}\begin{bmatrix} l_0 \\ r_0 \end{bmatrix} = \begin{bmatrix} l \\ r \\ c \end{bmatrix}$$

$$M_{PDC} = \begin{bmatrix} c_{11} & c_{12} \\ c_{21} & c_{22} \\ c_{31} & c_{32} \end{bmatrix}$$

Equation 11

where $l_0$, $r_0$, $l$, $r$, $c$ denote input audio signals L0 and R0, a left half plane signal (Ls+Lf), a right half plane signal (Rf+Rs), and a center signal (C) ; and $M_{PDC}$ denotes an CPC parameter vector extracted in the CPC/CLD parsing unit.

16. The apparatus of claim 15, wherein the CLD parameter extracted in the CPC/CLD parsing unit is level difference information between left signal components and level difference information between right signal components, and the gain factor conversion unit calculates the power gains of the left signal components (Ls, Lf) and the power gains of the right signal components (Rf, Rs) from the extracted center signal, the left half plane signal, and the right half plane signal based on the CLD parameter.

17. The apparatus of claim 16, wherein the gain factor control unit calculates a controlled power gain ($_{out}G_m$) expressed as Equation 12 by controlling the power gain of the input audio signal extracted in the gain factor conversion unit based on the control information on the rendering of the input audio signal according to a panning law, the Equation 12 being expressed as:

$$_{out}G_m = \begin{bmatrix} _{out}g_m^1 \\ _{out}g_m^2 \\ \vdots \\ _{out}g_m^M \end{bmatrix} = [\alpha,\beta]_{M \times N}\, G_m$$

Equation 12

where $G_m$ denotes a power gain vector of an input audio signal;
$_{out}G_m$ denotes a controlled power gain vector;
M denotes the number of output audio signals;
N denotes the number of input audio signals; and $[\alpha,\beta]_{M \times N}$ denotes a M × N vector composed of coefficients $\alpha_k$ and $\beta_k$ that are calculated to map the input audio signal ( $g_m^k$ ) to a position between arbitrary output audio signals.

18. The apparatus of claim 4 or 17, wherein the panning law is a Constant Power Panning (CPP) Law, and

the coefficients $\alpha_k$ and $\beta_k$ are $\alpha_k = \cos(\theta_k)$, $\beta_k = \sin(\theta_k)$, respectively,

where $\theta_k$ is angle information between the output audio signals that the input audio signal ($g_m^k$) is mapped.

19. The apparatus of claims 2 or 14, wherein the CLD conversion unit converts the controlled power gain into the CLD value based on Equation 13 expressed as:

$$converted\ CLD_m^i = 20\log_{10}\frac{_{out}g_m^k}{_{out}g_m^j} \qquad \text{Equation } 13$$

where the converted $CLD_m^i$ is a CLD value obtained from the conversion in the CLD conversion unit;

$i$ denotes a CLD index ($1 \le i \le M-1$) ;

M denotes the number of audio signals in an $m^{th}$ sub-band;

$_{out}g_m^k$ and $_{out}g_m^j$ denote controlled power gains four $j^{th}$ and $k^{th}$ audio signals in the $m^{th}$ sub-band, respectively.

20. An apparatus according to claim 1,

wherein the spatial cue information is an InterChannel Correlation (ICC) value representing a correlation between input audio signals, and

the spatial cue rendering means controls an ICC parameter through a linear interpolation process based on Equation 14 expressed as:

$$ICC_{Ls.Lf} = (1-\eta)ICC_{Ls.Lf} + \eta ICC_{Rs.Rf}$$

$$ICC_{Rs.Rf} = (1-\eta)ICC_{Rs.Rf} + \eta ICC_{Ls.Lf}$$

$$\eta = \frac{\theta_{pan}}{\pi}, \qquad \theta_{pan} \le \pi$$

$$\eta = 1 - \frac{\theta_{pan} - \pi}{\pi}, \qquad \theta_{pan} > \pi$$

$$\text{Equation } 14$$

where $\theta_{pan}$ denotes control information on rendering of the input audio signal.

21. The apparatus of one of claims 1, 5, 10, 14, or 20, wherein the decoding means outputs a binaural stereo signal according to a binaural decoding method to which an HRTF coefficient is applied.

22. A method for controlling rendering of audio signals, comprising the steps of:

    a) decoding an input audio signal, which is a down-mixed signal that is encoded in a Spatial Audio Coding (SAC)

34

method, by using an SAC decoding method; and

b) receiving spatial cue information and control information on rendering of the input audio signals and controlling the spatial cue information in a spatial cue domain based on the control information,

wherein rendering is performed in the decoding step a) onto the input audio signals based on a controlled spatial cue information controlled in the spatial cue rendering step b), whereby

the spatial cue information is a Channel Level Difference (CLD) indicating a level different among the input audio signals; and

the spatial cue rendering step b) includes the steps of: b1) extracting a CLD parameter from the CLD transmitted from an encoding means;

b2 ) extracting a power gain of each audio signal from the CLD parameter extracted in the CLD parsing step b1); and

b3 ) calculating a controlled power gain by controlling the power gain of each audio signal extracted in the gain factor conversion step b2 ) based on the control information on the rendering of the input audio signals,and

b4 ) converting the controlled power gain outputted from the gain factor control step b3 ) into a CLD value, and

the decoding step a) uses the CLD value acquired from the conversion in the CLD conversion step b4 ) as the controlled spatial information which is needed to perform the rendering of the input audio signal.

23. A method for controlling rendering of audio signals, comprising the steps of:

a) decoding an input audio signal, which is a down-mixed signal encoded in a Spatial Audio Coding (SAC) method, by using the SAC method; and

b) receiving spatial cue information and control information on the rendering of the input audio signal and controlling the spatial cue information in a spatial cue domain based on the control information, wherein rendering of the input audio signal is performed in the decoding step a) based on spatial cue information controlled in the spatial cue rendering step b ), and the spatial cue information is a Channel Prediction Coefficient (CPC) representing a down-mixing ratio of input audio signals and a Channel Level Difference (CLD) value representing a level difference between input audio signals, and

the spatial cue rendering step b) includes:

b1) extracting a CPC parameter and a CLD parameter from a CPC and a CLD transmitted from an encoding means; b2 ) extracting power gains of each signal by extracting a center signal, a left half plane signal, and a right half plane signal from the CPC parameter extracted in the CPC/CLD parsing step b1), and extracting a power gain of a left signal component and a right signal component from the CLD parameter; and

b3 ) calculating a controlled power gain by controlling a power gain of each audio signal extracted in the gain factor conversion step b2 ) based on control information on rendering of the input audio signal,

b4 ) converting the controlled power gain outputted in the gain factor control step b3) into a CLD value, and the CLD value acquired from the conversion in the CLD conversion step b4 ) is used in the decoding step a) as the controlled spatial information which is needed to perform the rendering of the input audio signal.

**Patentansprüche**

1. Vorrichtung zum Steuern des Renderns von Audiosignalen, aufweisend :

eine Dekodiereinrichtung (203) zum Dekodieren eines Eingangs- Audiosignals, dass ein heruntergemischtes Signal ist, das durch ein Spatial Audio Coding (SAC)- Verfahren codiert wurde, unter Verwendung eines SAC- Dekodierverfahrens; und

eine Räumlicher- Hinweis- Rendering- Einrichtung (201) zum Empfangen von Räumlicher- Hinweisinformation und Steuerinformation über das Rendern des Eingangs- Audiosignals und zum Steuern der Räumlicher- Hinweisinformation in einer Räumlicher- Hinweis- Domäne basierend auf der Steuerinformation;

wobei die Dekodiereinrichtung das Rendern des Eingangs- Audiosignals basierend auf einer gesteuerten Räumlichen- Hinweisinformation, die gesteuert wird durch die Räumlicher- Hinweis- Rendering- Einrichtung, durchführt

wobei die Räumlicher-Hinweisinformation eine Kanalpegeldifferenz (CLD) ist, die einen Pegel angibt, der unter Eingangs-Audiosignalen unterschiedlich ist, und wobei

die Räumlicher- Hinweis- Rendering- Einrichtung einschließt:

eine CLD- Parsing- Einheit (403) zum Extrahieren eines CLD- Parameters von der CLD, die von einer Codiereinrichtung übertragen wird;

eine Verstärkungsfaktor-Konversionseinheit (403) zum Extrahieren einer Leistungsverstärkung für jedes Audiosignal von dem CLD-Parameter, der in der CLD-Parsingeinheit extrahiert wurde; und

eine Verstärkungsfaktor-Steuereinheit (405) zum Berechnen einer gesteuerten Leistungsverstärkung durch Steuern der Leistungsverstärkung jedes Audiosignals, das in der Verstärkungsfaktor-Konversionseinheit extrahiert wurde, basierend auf der Steuerinformation über das Rendern des Eingangs-Audiosignals; und

eine CLD-Konversionseinheit (407) zum Konvertieren der gesteuerten Leistungsverstärkung, die von der Verstärkungsfaktor-Steuereinheit ausgegeben wurde, in einen CLD-Wert, wobei

die Dekodiereinrichtung den CLD-Wert, der von der Konversion in der CLD-Konversionseinheit erhalten wurde, als gesteuerte Räumlicher-Hinweis-Information verwendet, die benötigt wird, um das Rendern des Eingangs-Audiosignals durchzuführen.

2. Die Vorrichtung nach Anspruch 1, wobei die Räumlicher-Hinweis-Information ausgedrückt wird als Gleichung 1, und die Gleichung 1 ausgedrückt wird als:

$$CLD_m^i = 10 \log_{10} \frac{P_m^k}{P_m^j}$$

Gleichung 1

wobei i einen Index von CLD ($1 \leq i \leq N-1$)angibt;

N die Anzahl der Eingangs-Audiosignale in einem m-ten Sub-Band angibt; und

$P_m^k$ ein Sub-Band für ein k-tes Eingangs-Audiosignal in einem m-ten Sub-Band angibt.

3. Die Vorrichtung nach Anspruch 2, wobei die Verstärkungsfaktor-Konversionseinheit eine Leistungsverstärkung ($G_m$) des Eingangs-Audiosignals extrahiert, die ausgedrückt wird als Gleichung 2:

$$G_m = \begin{bmatrix} g_m^1 \\ g_m^2 \\ \cdots \\ g_m^k \\ \cdots \\ g_m^N \end{bmatrix}$$

$$g_m^j = \frac{1}{\sqrt{1+10^{CLD_m^i/10}}} = \frac{\sqrt{P_m^j}}{\sqrt{P_m^k + P_m^j}}$$

$$g_m^k = g_m^j \cdot 10^{CLD_m^i/20} = \frac{\sqrt{P_m^j}}{\sqrt{P_m^k + P_m^j}}$$

Gleichung 2

wobei m den Index eines Subbands bezeichnet;

$g_m^k$ eine Subband-Leistungsverstärkung eines k-ten Eingangs-Audiosignals ($1 \le k \le N$) in einem m-ten Subband bezeichnet;

und

$G_m$ eine Leistungsverstärkung aller Eingangs-Audiosignale in dem m-ten Subband bezeichnet.

4. Die Vorrichtung nach Anspruch 3, wobei die Verstärkungsfaktor- Steuereinheit eine gesteuerte Leistungsverstärkung ($_{out}G_m$) berechnet, die ausgedrückt wird als Gleichung 3, durch Steuern der Leistungsverstärkung ($G_m$) des Eingangs- Audiosignals, das in der Verstärkungsfaktor- Konversionseinheit extrahiert wird basierend auf der Steuerinformation des Renderns des Eingangs- Audiosignals in Übereinstimmung mit einem Panning- Law, wobei Gleichung 3 ausgedrückt wird als :

$$_{out}G_m = \begin{bmatrix} _{out}g_m^1 \\ _{out}g_m^2 \\ \vdots \\ _{out}g_m^M \end{bmatrix} = [\alpha, \beta]_{M \times N} \, G_m$$

Gleichung 3

wobei M die Anzahl der Ausgangs- Audiosignale bezeichnet;

N die Anzahl der Eingangs- Audiosignale bezeichnet; und

$[\alpha, \beta]_{MxN}$ einen Vektor MxN bezeichnet, der sich zusammensetzt aus den Koeffizienten $\alpha_k$ und $\beta_k$ die berechnet werden, um die Eingangs- Audiosignale ($g^k_m$) auf eine Position zwischen beliebigen Ausgangs- Audiosignalen zu mappen.

5. **5.** Vorrichtung nach Anspruch 1,
wobei die Dekodiereinrichtung ein Rendern des Eingangs- Audiosignals basierend auf Räumlicher- Hinweis- Information durchführt, die gesteuert wird durch die Räumlicher- Hinweis- Rendering- Einrichtung, und
wobei die Räumlicher- Hinweis- Information ein Kanalpegeldifferenz (CLD)- Wert ist, der eine Pegeldifferenz zwischen Eingangs- Audiosignalen repräsentiert und ausgedrückt wird als $D^Q_{CLD(ott,l,m)}$, und
wobei m einen Index eines Subbands bezeichnet und I einen Index eines Parametersatzes bezeichnet, der gesetzt wird in $D^Q_{CLD(ott,l,m)}$.

**6.** Vorrichtung nach Anspruch 5, wobei Verstärkungsfaktor-Konversionseinheit die Leistungsverstärkung ($G_m$) des Eingangs-Audiosignals extrahiert, die ausgedrückt wird als Gleichung 5 :

$$G_m = \begin{bmatrix} pG_{l,m}^{Lf} \\ pG_{l,m}^{Ls} \\ pG_{l,m}^{Rf} \\ pG_{l,m}^{Rs} \\ pG_{l,m}^{C} \\ pG_{l,m}^{lfe} \end{bmatrix}$$

$$pG_{l,m}^{Lf} = G_{1,l,m}^{L} \cdot G_{3,l,m}^{Lf}$$

$$pG_{l,m}^{Ls} = G_{1,l,m}^{L} \cdot G_{3,l,m}^{Ls}$$

$$pG_{l,m}^{Rf} = G_{1,l,m}^{R} \cdot G_{4,l,m}^{Rf}$$

$$pG_{l,m}^{Rs} = G_{1,l,m}^{R} \cdot G_{4,l,m}^{Rs}$$

$$pG_{l,m}^{C} = G_{1,l,m}^{Clfe}, \quad pG_{l,m}^{lfe} = 0 \qquad (m>1)$$

$$pG_{l,m}^{lfe} = G_{1,l,m}^{Clfe} \cdot G_{2,l,m}^{lfe}, \quad pG_{l,m}^{C} = G_{1,l,m}^{Clfe} \cdot G_{2,l,m}^{C} \quad (m=0,1)$$

$$G_{0,l,m}^{Clfe} = \frac{1}{\sqrt{1+10^{D_{CLD}^{Q}(0,l,m)/10}}}$$

$$G_{0,l,m}^{LR} = G_{0,l,m}^{Clfe} \cdot 10^{D_{CLD}^{Q}(0,l,m)/20}$$

Gleichung 5

wobei ein Koeffizient von $G_m$ ein Vektor ist, der eine Leistungsverstärkung eines m-ten Subbands repräsentiert; und $G_m$ ein Vektor ist, der eine Leistungsverstärkung aller Eingangs-Audiosignale in dem m-ten Subband repräsentiert.

7. Die Vorrichtung nach Anspruch 6, wobei die Verstärkungsfaktor- Steuereinheit eine gesteuerte Leistungsverstärkung ($_{out}G_m$) berechnet, die ausgedrückt wird als Gleichung 6, durch Steuern der Leistungsverstärkung des Eingangs-Audiosignals, das in der Verstärkungsfaktor- Konversionseinheit extrahiert wird basierend auf der Steuerinformation über das Rendern des Eingangs- Audiosignals gemäß einem Panning- Law, wobei Gleichung 6 ausgedrückt wird als:

$$_{out}G_m = \begin{bmatrix} _{out}g_m^1 \\ _{out}g_m^2 \\ \vdots \\ _{out}g_m^M \end{bmatrix} = [\alpha, \beta]_{M \times N} \, G_m$$

Gleichung 6

wobei M die Anzahl von Ausgangs- Audiosignalen bezeichnet;

Wobei N die Anzahl von Eingangs- Audiosignalen bezeichnet; und

$[\alpha, \beta]_{M \times N}$ einen Vektor MxN bezeichnet, der sich zusammensetzt aus den Koeffizienten $\alpha_k$ und $\beta_k$ die berechnet werden, um die Eingangs- Audiosignale ($pG^k_{l,m}$) auf eine Position zwischen beliebigen Ausgangs- Audiosignalen zu mappen.

8.  Vorrichtung nach Anspruch 7, wobei das Panning Law ein Konstant- Leistungs- Panning- Law ist und die Koeffizienten $\alpha_k$ und $\beta_k$ ausgedrückt werden als Gleichung 7 :

$$\alpha_k = \cos(\theta_m), \beta_k = \sin(\theta_m)$$

$$\theta_m = \frac{\theta_{pan,k} - \theta_{ref}}{apertuer - \theta_{ref}} \times \frac{\pi}{2}$$

Gleichung 7

wobei $\theta_{pan,k}$ Winkelinformationen zwischen den Ausgangs- Audiosignalen, auf die das Eingangs- Audiosignal ($pG^k_{l,m}$) gemappt wird, bezeichnet;

apertuer Winkelinformationen zwischen den Ausgangs- Audiosignalen bezeichnet; und

$\theta_{ref}$ Winkelinformation eines Referenz- Ausgangs- Audiosignals zwischen den Ausgangs- Audiosignalen bezeichnet.

9.  Vorrichtung nach Anspruch 5, wobei die CLD-Konversionseinheit die gesteuerte Leistungsverstärkung in den CLD-Wert konvertiert basierend auf Gleichung 8, die ausgedrückt wird als:

$$D_{CLD}^{modified}(0,l,m) = 20\log_{10}\left(\frac{pG_{Lf}(l,m)}{pG_{Ls}(l,m)}\right)$$

$$D_{CLD}^{modified}(1,l,m) = 20\log_{10}\left(\frac{pG_{Rf}(l,m)}{pG_{Rs}(l,m)}\right)$$

$$D_{CLD}^{modified}(2,l,m) = 10\log_{10}\left(\frac{pG_{Lf}^2(l,m)+pG_{Ls}^2(l,m)}{pG_{Rf}^2(l,m)+pG_{Rs}^2(l,m)}\right)$$

$$D_{CLD}^{modified}(3,l,m) = 20\log_{10}\left(\frac{pG_C(l,m)}{pG_{lfe}(l,m)}\right)$$

$$D_{CLD}^{modified}(4,l,m) = 10\log_{10}\left(\frac{pG_{Lf}^2(l,m)+pG_{Ls}^2(l,m)+pG_{Rf}^2(l,m)+pG_{Rs}^2(l,m)}{pG_C^2(l,m)+pG_{lfe}^2(l,m)}\right)$$

Gleichung 8

**10.** Vorrichtung nach Anspruch 1,
wobei ein Zentrum- Signal (C), ein linkes Halbebenensignal (Lf+Ls) und ein rechtes Halbebenensignal (Rf+Rs) extrahiert werden aus den heruntergemischten Signalen L0 und R0 basierend auf Gleichung 9, und
die Räumlicher- Hinweis- Information ein Kanalpegeldifferenz (CLD)- Wert ist, der eine Pegeldifferenz zwischen Eingangs- Audiosignalen repräsentiert und ausgedrückt wird als
$CLD_{LR/Clfe}$, $CLD_{L/R}$, $CLD_{C/lfe}$ ; $CLD_{Lf/Ls}$ und $CLD_{Rf/Rs}$, und
Gleichung 9 ausgedrüct wird als :

$$\mathbf{R}_{l}^{\prime\prime,m} = \begin{bmatrix} w_{11}^{\prime,m} & w_{12}^{\prime\prime,m} \\ w_{21}^{\prime\prime,m} & w_{22}^{\prime,m} \\ w_{31}^{\prime,m}\sqrt{2} & w_{32}^{\prime,m}\sqrt{2} \\ w_{11}^{\prime,m} & w_{12}^{\prime,m} \\ w_{21}^{\prime\prime,m} & w_{22}^{\prime,m} \end{bmatrix}, \quad 0 \le m < \mathbf{m}_{ttlLowProc}(0), 0 \le l < L$$

$$w_{12}^{\prime\prime,m} = \frac{P_{pan}^{L}}{\sqrt{P_{C}/2 + P_{Rf} + P_{Rs}}}$$

$$w_{21}^{\prime\prime,m} = \frac{P_{pan}^{R}}{\sqrt{P_{C}/2 + P_{Lf} + P_{Ls}}}$$

$$w_{13}^{\prime\prime,m} = \frac{P_{pan}^{CL}}{\sqrt{Pc/2 + P_{Rf} + P_{Rs}}}$$

$$w_{31}^{\prime\prime,m} = \frac{P_{pan}^{CR}}{\sqrt{P_{C}/2 + P_{Lf} + P_{Ls}}}$$

$$\left(w_{11}^{\prime\prime,m}\right)^2 + \left(w_{21}^{\prime\prime,m}\right)^2 + \left(w_{31}^{\prime\prime,m}\right)^2 = 1$$

$$\left(w_{12}^{\prime\prime,m}\right)^2 + \left(w_{22}^{\prime\prime,m}\right)^2 + \left(w_{32}^{\prime\prime,m}\right)^2 = 1$$

Gleichung 9

wobei $w_{ij}^{l,m}$ einen Koeffizient ist, der erzeugt wird aus einer Leistungsverstärkung, die berechnet wird basierend auf den CLD- Werten ($CLD_{LR/Clfe}$, $CLD_{L/R}$, $CLD_{C/lfe}$; $CLD_{Lf/Ls}$ und $CLD_{Rf/Rs}$) (wobei i und j Indizes von Vektormatrizen sind ; m ein Index eines Subbands ist; und I ein Index eins Parametersatzes ist) ;

$m_{tttLowProc}$ die Anzahl der Subbänder ist;

$P_c$, $P_{Lf}$, $P_{Ls}$, $P_{Rf}$, $P_{Rs}$ Leistungsverstärkungen eines Zentrumsignals, eines linken Frontsignals, eines linken Rücksignals, eines rechten Frontsignals und eines rechten Rücksignals sind;

$PL_{pan}$ eine projezierte Leistung bezeichnet basierend auf einem Panning- Law im Verhältnis zu einer Kombination von Pc, $P_{Lf}$, $P_{Ls}$ ;

$PR_{pan}$ eine projezierte Leistung bezeichnet basierend auf einem Panning- Law im Verhältnis zu einer Kombination Pc, $P_{Rf}$, $P_{Rs}$; und

$PCL_{pan}$ und $PCR$ jeweils Panning- Leistungsverstärkungen für eine linke Halbebene und eine rechte Halbebene bezüglich eines Zentrum- Kanals sind.

11. Vorrichtung nach Anspruch 10, wobei die Verstärkungsfaktor- Konversionseinheit Leistungsverstärkungen ($P_c$, $P_{Lf}$, $P_{Ls}$, $P_{Rf}$, $P_{Rs}$) der Eingangs- Audiosignale basierend auf CLD- Werten ($CLD_{LR/Clfe}$, $CLD_{L/R}$, $CLD_{C/lfe}$; $CLD_{Lf/Ls}$ und $CLD_{Rf/Rs}$) extrahiert.

12. Vorrichtung nach Anspruch 11, wobei die Verstärkungsfaktor-Steuereinheit zusätzlich die Leistungsverstärkungen ($PL_{pan}$, $PR_{pan}$, $PCL_{pan}$ und $PCR_{pan}$) berechnet durch Steuern der Leistungsverstärkungen ($P_c$, $P_{Lf}$, $P_{Ls}$, $P_{Rf}$, $P_{Rs}$) der Eingangs-Audiosignale, die in der Verstärkungsfaktor-Konversionseinheit extrahiert werden basierend auf Steuerinformation über das Rendern der Eingangs-Audiosignale, und

wobei gesteuerte Leistungsverstärkungen berechnet werden basierend auf den erhaltenen Leistungsverstärkungen

$(P_C, P_{Lf}, P_{Ls}, P_{Rf}, P_{Rs}, P^L_{pan}, P^R_{pan}, P^{CL}_{pan}$ und $P^{CR}_{pan})$.

**13.** Vorrichtung nach Anspruch 12, wobei die gesteuerten Leistungsverstärkungen berechnet werden basierend auf Gleichung 10, die ausgedrückt wird als:

$$_{out}g^{Lf}_m = \sqrt{P_{Lf} + P^L_{pan}}$$

$$_{out}g^{Ls}_m = \sqrt{P_{Ls}}$$

$$_{out}g^{Rf}_m = \sqrt{P_{Rf} + P^R_{pan}}$$

$$_{out}g^{Rs}_m = \sqrt{P_{Rs}}$$

$$_{out}g^{CL}_m = \sqrt{P_C / 2}$$

$$_{out}g^{CR}_m = \sqrt{P_C / 2}$$

Gleichung 10

**14.** Vorrichtung zum Steuern des Renderns von Audiosignalen, aufweisend :

eine Dekodiereinichtung (201) zum Dekodieren eines Eingangs- Audiosignals, das ein heruntergemischtes Signal ist, das durch ein Spatial Audio Coding (SAC)- Verfahren codiert wurde, unter Verwendung eines SAC-Dekodierverfahrens; und

eine Räumlicher- Hinweis- Rendering- Einrichtung (203) zum Empfangen von Räumlicher- Hinweisinformation und Steuerinformation über das Rendern des Eingangs- Audiosignals und zum Steuern der Räumlicher- Hinweisinformation in einer Räumlicher- Hinweis- Domäne basierend auf der Steuerinformation;

wobei die Dekodiereinrichtung das Rendern des Eingangs- Audiosignals basierend auf einer gesteuerten Räumlichen- Hinweisinformation, die gesteuert wird durch die Räumlicher- Hinweis- Rendering- Einrichtung, durchführt

wobei die Räumlicher-Hinweisinformation ein Kanalpegeldifferenz (CLD)-Wert ist, der eine Pegeldifferenz zwischen Eingangs-Audiosignalen repräsentiert und ein Kanal-Prädiktionskoeffizient (CPC), der ein Heruntermisch-Verhältnis von Eingangs-Audiosignalen repräsentiert, und

die Räumlicher- Hinweis- Rendering- Einrichtung einschließt:

eine CPC/CLD- Parsing- Einheit (701) zum Extrahieren eines CPC- Parameters und eines CLD- Parameters von einem CPC und einer CLD, die von einer Codiereinrichtung übertragen werde;

eine Verstärkungsfaktor-Konversionseinheit (703) zum Extrahieren von Leistungsverstärkungen von jedem Signal durch Extrahieren eines Zentrum-Signals, eines linken Halbebenensignal und eines rechten Halbebenensignal aus dem CPC-Parameter, der extrahiert wurde in der CPC/CLD-Parsingeinheit, und Extrahieren von Leistungsverstärkungen der linken Signalkomponenten und der rechten Signalkomponenten aus dem CLD-Parameter; und

eine Verstärkungsfaktor-Steuereinheit (705) zum Berechnen einer gesteuerten Leistungsverstärkung durch Steuern einer Leistungsverstärkung jedes Audiosignals, das in der Verstärkungsfaktor-Konversionseinheit extrahiert wurde, basierend auf der Steuerinformation über das Rendern des Eingangs-Audiosignals; und

eine CLD-Konversionseinheit (707) zum Konvertieren der gesteuerten Leistungsverstärkung, die von der Verstärkungsfaktor-Steuereinheit ausgegeben wurde, in einen CLD-Wert, wobei

die Dekodiereinrichtung den CLD-Wert, der von der Konversion in der CLD-Konversionseinheit erhalten wurde, als die gesteuerte Räumlicher-Hinweis-Information verwendet, die benötigt wird, um das Rendern des Eingangs-Audiosignals durchzuführen.

15. Vorrichtung nach Anspruch 14, wobei die Verstärkungsfaktor-Konversionseinheit ein Zentrum-Signal, ein linkes Halbebenensignal und ein rechtes Halbebenensignal aus dem CPC-Parameter extrahiert, der in der CPC/CLD-Pasing Einheit extrahiert wurde, und zwar basierend auf Gleichung 11, die ausgedrückt wird als :

$$M_{PDC} \begin{bmatrix} l_0 \\ r_0 \end{bmatrix} = \begin{bmatrix} l \\ r \\ c \end{bmatrix}$$

$$M_{PDC} = \begin{bmatrix} c_{11} & c_{12} \\ c_{21} & c_{22} \\ c_{31} & c_{32} \end{bmatrix}$$

Gleichung 11

wobei $l_0$, $r_0$, l, r, c Eingangs-Audiosignale L0 und R0 bezeichnen, ein linkes Halbebenensignal (Ls + Lf), ein rechtes Halbebenensignal (Rf + Rs), und ein Zentrum-Signal (C) bezeichnen, und $M_{PDC}$ einen CPC-Parametervektor bezeichnet, der extrahiert wird in der CPC/CLD-Pasing Einheit.

16. Vorrichtung nach Anspruch 15, wobei der CLD-Parameter, der in der CPC/CLD-18 Einheit extrahiert wird, Pegel-Differenzinformation zwischen linken Signalkomponenten und Pegel-Differenzinformation zwischen rechten Signalkomponenten ist, und
wobei die Verstärkungsfaktor-Konversionseinheit die Leistungsverstärkungen der linken Signalkomponenten (Ls, Ls) und die Leistungsverstärkungen der rechten Signalkomponenten (Rf, Rs) von dem extrahierten Zentrum-Signal, dem linken Halbebenensignal und dem rechten Halbebenensignal basierend auf dem CLD-Parameter berechnet.

17. Vorrichtung nach Anspruch 16, wobei die Verstärkungsfaktor- Steuereinheit eine gesteuerte Leistungsverstärkung ($_{out}G_m$), die ausgedrückt wird als Gleichung 12, berechnet durch Steuern der Leistungsverstärkung des Eingangs-Audiosignals, das extrahiert wird in der Verstärkungsfaktor- Konversionseinheit basierend auf der Steuerinformation über das Rendern des Eingangs- Audiosignals gemäß einem Panning- Law, wobei Gleichung 12 ausgedrückt wird als:

$$_{out}G_m = \begin{bmatrix} _{out}g_m^1 \\ _{out}g_m^2 \\ \vdots \\ _{out}g_m^M \end{bmatrix} = [\alpha, \beta]_{M \times N} \, G_n$$

Gleichung 12

wobei $G_m$ einen Leistungsverstärkungsvektor eines Eingangs- Audiosignals bezeichnet;

$_{out}G_m$ einen gesteuerten Leistungsverstärkungsvektor bezeichnet;

M die Anzahl von Ausgangs- Audiosignalen bezeichnet;

N die Anzahl von Eingangs- Audiosignalen bezeichnet; und

$[\alpha, \beta]_{MxN}$ einen Vektor MxN bezeichnet, der sich zusammensetzt aus den Koeffizienten $\alpha_k$ und $\beta_k$ die berechnet werden, um die Eingangs- Audiosignale ($g^k_m$) auf eine Position zwischen beliebigen Ausgangs- Audiosignalen zu mappen.

**18.** Vorrichtung nach Anspruch 4 oder 17, wobei das Panning- Law ein Konstant- Leistungs- Panning- Law ist und die Koeffizienten $\alpha_k$ und $\beta_k$ jeweils $\alpha_k = \cos(\theta_k)$, $\beta_k = \sin(\theta_k)$ sind,

wobei $\theta_k$ Winkelinformation zwischen den Ausgangs- Audiosignalen ist, auf die das Eingangs- Audiosignal gemappt wird.

**19.** Vorrichtung nach Anspruch 2 oder 14, wobei die CLD- Konversionseinheit die gesteuerte Leistungsverstärkung in den CLD- Wert konvertiert basierend auf Gleichung 13, die ausgedrückt wird als:

$$converted\ CLD^i_m = 20\log_{10} \frac{_{out}g^k_m}{_{out}g^j_m}$$

Gleichung 13

wobei die converted $CLD^i_m$ ein CLD- Wert ist, der erhalten wird aus der Konversion in der CLD- Konversionseinheit;

i einen CLD- Index ($1 \le i \le M-1$) bezeichnet;

M die Anzahl der Audiosignale in einem m- ten Subband bezeichnet;

$_{out}g^k_m$ und $_{out}g^j_m$ jeweils die gesteuerten Leistungsverstärkungen für die j- ten und k- ten Audiosignale in dem m- ten Subband bezeichnen.

**20.** Vorrichtung nach Anspruch 1,

wobei die Räumlicher- Hinweis- Information ein Inter- Kanal- Korrelations (ICC)- Wert ist, der eine Korrelation zwischen Eingangs- Audiosignalen repräsentiert, und

die Räumlicher- Hinweis- Rendering- Einrichtung einen ICC- Parameter durch einen linearen Interpolationsprozess steuert basierend auf Gleichung 14, die ausgedrückt wird als:

$$ICC_{Ls,Lf} = (1-\eta)ICC_{Ls,Lf} + \eta ICC_{Rs,Rf}$$

$$ICC_{Rs,Rf} = (1-\eta)ICC_{Rs,Rf} + \eta ICC_{Ls,Lf}$$

$$\eta = \frac{\theta_{pan}}{\pi}, \quad \theta_{pan} \le \pi$$

$$\eta = 1 - \frac{\theta_{pan} - \pi}{\pi}, \quad \theta_{pan} > \pi$$

Gleichung 14

wobei $\theta_{pan}$ Steuerinformation über das Rendern des Eingangs- Audiosignals bezeichnet.

**21.** Vorrichtung nach einem der Ansprüche 1, 5, 10, 14 oder 20, wobei die Dekodiereinrichtung ein binaurales Stereosignal gemäß einem binauralen Dekodierverfahren ausgibt, auf das ein HRTF-Koeffizient angewendet wird.

**22.** Verfahren zum Steuern des Renderns von Audiosignalen, aufweisend die Schritte:

a) Dekodieren eines Eingangs- Audiosignals, das ein heruntergemischtes Signal ist, das durch ein Spatial Audio Coding (SAC)- Verfahren codiert wurde, unter Verwendung eines SAC- Dekodierverfahrens; und

b) Empfangen von Räumlicher-Hinweisinformation und Steuerinformation über das Rendern des Eingangs-Audiosignals und zum Steuern der Räumlicher-Hinweisinformation in einer Räumlicher-Hinweis-Domäne basierend auf der Steuerinformation;

wobei das Rendern durchgeführt wird in dem Dekodierschritt a) auf den Eingangs- Audiosignalen basierend auf einer gesteuerten Räumlichen- Hinweisinformation, die gesteuert wird in dem Räumlicher- Hinweis- Rendering-Schrit b), wobei

die Räumlicher- Hinweisinformation eine Kanalpegeldifferenz (CLD) ist, die einen Pegel angibt, der unter Eingangs-Audiosignalen unterschiedlich ist, und wobei

der Räumlicher- Hinweis- Rendering- Schritt b) einschließt:

b1) Extrahieren eines CLD- Parameters von der CLD, die von einer Codiereinrichtung übertragen wird;

b2) Extrahieren einer Leistungsverstärkung jedes Audiosignals von dem CLD-Parameter, der in dem CLD-Parsingschritt b1) extrahiert wurde; und

b3) Berechnen einer gesteuerten Leistungsverstärkung durch Steuern der Leistungsverstärkung jedes Audiosignals, das in dem Verstärkungsfaktor-Konversionsschritt b2) extrahiert wurde, basierend auf der Steuerinformation über das Rendern des Eingangs-Audiosignals; und

b4) Konvertieren der gesteuerten Leistungsverstärkung, die von der Verstärkungsfaktor-Steuerschritt b3) ausgegeben wurde, in einen CLD-Wert, wobei

der Dekodierschritt a) den CLD-Wert, der von der Konversion in dem CLD-Konversionsschritt b4) erhalten wurde, als gesteuerte Räumlicher-Hinweis-Information verwendet, die benötigt wird, um das Rendern des Eingangs-Audiosignals durchzuführen.

**23.** Verfahren zum Steuern des Renderns von Audiosignalen, aufweisend die Schritte:

a) Dekodieren eines Eingangs- Audiosignals, dass ein heruntergemischtes Signal ist, das durch ein Spatial Audio Coding (SAC)- Verfahren codiert wurde, unter Verwendung eines SAC- Dekodierverfahrens; und

b) Empfangen von Räumlicher-Hinweisinformation und Steuerinformation über das Rendern des Eingangs-Audiosignals und zum Steuern der Räumlicher-Hinweisinformation in einer Räumlicher-Hinweis-Domäne basierend auf der Steuerinformation;

wobei Rendern des Eingangs- Audiosignals durchgeführt wird im Dekodierschritt a) basierend auf einer gesteuerten Räumlichen- Hinweisinformation, die gesteuert wird in dem Räumlicher- Hinweis- Rendering- Schritt b), und

wobei die Räumlicher- Hinweisinformation ein Kanal- Prädiktionskoeffizient (CPC) ist, der ein Heruntermisch- Verhältnis von Eingangs- Audiosignalen repräsentiert, und ein Kanalpegeldifferenz (CLD)- Wert ist, der eine Pegeldifferenz zwischen Eingangs- Audiosignalen repräsentiert, und

wobei der Räumlicher- Hinweis- Rendering- Schritt b) einschließt:

b1) Extrahieren eines CPC- Parameters und eines CLD- Parameters von einem CPC und einer CLD, die von einer Codiereinrichtung übertragen werden;

b2) Extrahieren von Leistungsverstärkungen von jedem Signal durch Extrahieren eines Zentrum-Signals, eines linken Halbebenensignals und eines rechten Halbebenensignals aus dem CPC-Parameter, der extrahiert wurde in dem CPC/CLD-Parsingschritt b1), und Extrahieren von Leistungsverstärkungen einer linken Signalkomponenten und einer rechten Signalkomponenten aus dem CLD-Parameter; und

b3) Berechnen einer gesteuerten Leistungsverstärkung durch Steuern einer Leistungsverstärkung jedes Audiosignals, das in dem Verstärkungsfaktor-Konversionsschritt b2) extrahiert wurde, basierend auf der Steuerinformation über das Rendern des Eingangs-Audiosignals; und

b4) Konvertieren der gesteuerten Leistungsverstärkung, die in dem Verstärkungsfaktor-Steuerschritt b4) ausgegeben wurde, in einen CLD-Wert, wobei
der CLD-Wert, der von der Konversion in der CLD-Konversionsschritt b4) erhalten wurde, im Dekodierschritt a) als die gesteuerte Räumlicher-Hinweis-Information verwendet wird, die benötigt wird, um das Rendern des Eingangs-Audiosignals durchzuführen.

**Revendications**

1. Appareil destiné à commander la restitution de signaux audio, comprenant :

   un moyen de décodage (203) pour décoder un signal audio d'entrée, qui est un signal mélangé-abaissé qui est codé dans un procédé de codage audio spatial (SAC), en utilisant un procédé de décodage SAC ; et
   un moyen de restitution de repère spatial (201) pour recevoir des informations de repère spatial et des informations de commande sur la restitution du signal audio d'entrée et commander les informations de repère spatial dans un domaine de repère spatial sur la base des informations de commande,
   dans lequel le moyen de décodage effectue la restitution des signaux audio d'entrée sur la base d'informations de repère spatial commandées qui sont commandées par le moyen de restitution de repère spatial,
   de telle manière que les informations de repère spatial soient une différence de niveau de canal (CLD) indiquant un niveau différent parmi les signaux audio d'entrée, et
   dans lequel le moyen de restitution de repère spatial comprend :

   une unité d'analyse syntaxique de CLD (401) pour extraire un paramètre de CLD à partir de la CLD transmise depuis un moyen de codage ;
   une unité de conversion de facteur de gain (403) pour extraire un gain de puissance de chaque signal audio à partir du paramètre de CLD extrait dans l'unité d'analyse syntaxique de CLD ; et
   une unité de commande de facteur de gain (405) pour calculer un gain de puissance commandé en commandant le gain de puissance de chaque signal audio extrait dans l'unité de conversion de facteur de gain sur la base des informations de commande sur la restitution des signaux audio d'entrée ; et
   une unité de conversion de CLD (407) pour convertir le gain de puissance commandé délivré par l'unité de commande de facteur de gain en une valeur de CLD, dans lequel
   le moyen de décodage utilise la valeur de CLD acquise à partir de la conversion dans l'unité de conversion de CLD en tant qu'informations spatiales commandées nécessaires pour effectuer la restitution du signal audio d'entrée.

2. Appareil selon la revendication 1, dans lequel les informations de repère spatial sont exprimées par l'équation 1, et l'équation 1 est exprimée par :

$$CLD_m^i = 10 \log_{10} \frac{P_m^k}{P_m^j}$$

Equation 1

où i indique un indice de CLD ($1 \leq i \leq N-1$) ;
N indique le nombre de signaux audio d'entrée dans une $m^{\text{ième}}$ sous-bande ; et
$P_m^k$ indique une puissance de sous-bande pour un $k^{\text{ième}}$ signal audio d'entrée dans une $m^{\text{ième}}$ sous-bande.

3. Appareil selon la revendication 2, dans lequel l'unité de conversion de facteur de gain extrait un gain de puissance ($G_m$) du signal audio d'entrée, qui est exprimé par l'équation 2 :

$$G_m = \begin{bmatrix} g_m^1 \\ g_m^2 \\ \cdots \\ g_m^k \\ \cdots \\ g_m^N \end{bmatrix}$$

$$g_m^j = \frac{1}{\sqrt{1 + 10^{CLD_m^i/10}}} = \frac{\sqrt{P_m^j}}{\sqrt{P_m^k + P_m^j}}$$

$$g_m^k = g_m^j \cdot 10^{CLD_m^i/20} = \frac{\sqrt{P_m^j}}{\sqrt{P_m^k + P_m^j}}$$

Equation 2

où m indique un indice d'une sous- bande ;

$g_m^k$ indique un gain de puissance de sous- bande d'un $k^{\text{ième}}$ signal audio d'entrée ($1 \leq k \leq N$) dans une $m^{\text{ième}}$ sous-bande ;

et

$G_m$ indique un gain de puissance de tous les signaux audio d'entrée dans la $m^{\text{ième}}$ sous- bande.

4. Appareil selon la revendication 3, dans lequel l'unité de commande de facteur de gain calcule un gain de puissance commandé ($_{out}G_m$) exprimé par l'équation 3 en commandant le gain de puissance ($G_m$) du signal audio d'entrée extrait dans l'unité de conversion de facteur de gain sur la base des informations de commande sur la restitution du signal audio d'entrée selon une loi panoramique, l'équation 3 étant exprimée par :

$$_{out}G_m = \begin{bmatrix} _{out}g_m^1 \\ _{out}g_m^2 \\ \vdots \\ _{out}g_m^M \end{bmatrix} = [\alpha, \beta]_{M \times N} \, G_m$$

Equation 3

où M indique le nombre de signaux audio de sortie ;

N indique le nombre de signaux audio d'entrée ; et

$[\alpha, \beta]_{M \times N}$ indique un vecteur MxN composé de coefficients $\alpha_k$ et $\beta_k$ qui sont calculés pour mapper le signal audio d'entrée ($g_m^k$) à une position entre des signaux audio de sortie arbitraires.

5. Appareil selon la revendication 1,
dans lequel le moyen de décodage effectue la restitution du signal audio d'entrée sur la base d'informations de repère spatial commandées par le moyen de restitution de repère spatial, et

les informations de repère spatial sont une valeur de différence de niveau de canal (CLD) représentant une différence de niveau entre des signaux audio d'entrée et exprimée par $D^Q_{CLD}$ (ott, l, m), et
m indiquant un indice d'une sous- bande et 1 indiquant un indice d'un ensemble de paramètres dans $D^Q_{CLD}$ (ott, l, m) .

6. Appareil selon la revendication 5, dans lequel l'unité de conversion de facteur de gain extrait le gain de puissance ($G_m$) du signal audio d'entrée qui est exprimé par l'équation 5 :

$$G_m = \begin{bmatrix} pG^{Lf}_{l,m} \\ pG^{Ls}_{l,m} \\ pG^{Rf}_{l,m} \\ pG^{Rs}_{l,m} \\ pG^{C}_{l,m} \\ pG^{lfe}_{l,m} \end{bmatrix}$$

$$pG^{Lf}_{l,m} = G^{L}_{1,l,m} \cdot G^{Lf}_{3,l,m}$$

$$pG^{Ls}_{l,m} = G^{L}_{1,l,m} \cdot G^{Ls}_{3,l,m}$$

$$pG^{Rf}_{l,m} = G^{R}_{1,l,m} \cdot G^{Rf}_{4,l,m}$$

$$pG^{Rs}_{l,m} = G^{R}_{1,l,m} \cdot G^{Rs}_{4,l,m}$$

$$pG^{C}_{l,m} = G^{Clfe}_{1,l,m}, \quad pG^{lfe}_{l,m} = 0 \qquad (m>1)$$

$$pG^{lfe}_{l,m} = G^{Clfe}_{1,l,m} \cdot G^{lfe}_{2,l,m}, \quad pG^{C}_{l,m} = G^{Clfe}_{1,l,m} \cdot G^{C}_{2,l,m} \quad (m=0,1)$$

$$G^{Clfe}_{0,l,m} = \frac{1}{\sqrt{1 + 10^{D^Q_{CLD}(0,l,m)/10}}}$$

$$G^{LR}_{0,l,m} = G^{Clfe}_{0,l,m} \cdot 10^{D^Q_{CLD}(0,l,m)/20}$$

Equation 5

où un coefficient de $G_m$ est un vecteur représentant un gain de puissance d'une $m$ième sous-bande ; et
$G_m$ est un vecteur représentant un gain de puissance de tous les signaux audio d'entrée dans la $m$ième sous-bande.

**7.** Appareil selon la revendication 6, dans lequel l'unité de commande de facteur de gain calcule un gain de puissance commandé ($_{out}G_m$) exprimé par l'équation 6 en commandant le gain de puissance ($G_m$) du signal audio d'entrée extrait dans l'unité de conversion de facteur de gain sur la base des informations de commande sur la restitution du signal audio d'entrée selon une loi panoramique, l'équation 6 étant exprimée par :

$$_{out}G_m = \begin{bmatrix} _{out}g_m^1 \\ _{out}g_m^2 \\ \vdots \\ _{out}g_m^M \end{bmatrix} = [\alpha, \beta]_{M \times N} \, G_m \qquad \text{Equation 6}$$

où M indique le nombre de signaux audio de sortie ;
N indique le nombre de signaux audio d'entrée ; et
$[\alpha, \beta]_{MxN}$ indique un vecteur MxN composé de coefficients $\alpha_k$ et $\beta_k$ qui sont calculés pour mapper le signal audio d'entrée ($pG^k_{l.m}$) à une position entre des signaux audio de sortie arbitraires.

**8.** Appareil selon la revendication 7, dans lequel la loi panoramique est une loi panoramique à puissance constante (CPP), et les coefficients $\alpha_k$ et $\beta_k$ sont exprimés par l'équation 7 :

$$\alpha_k = \cos(\theta_m), \beta_k = \sin(\theta_m)$$

$$\theta_m = \frac{\theta_{pan.k} - \theta_{ref}}{apertuer - \theta_{ref}} \times \frac{\pi}{2} \qquad \text{Equation 7}$$

où $\theta_{pan,k}$ indique des informations d'angle entre les signaux audio de sortie sur lesquels le signal audio d'entrée ($pG^k_{l.m}$) est mappé ;
apertuer indique des informations d'angle entre les signaux audio de sortie ; et
$\theta_{ref}$ indique des informations d'angle d'un signal audio de sortie de référence entre les signaux audio de sortie.

**9.** Appareil selon la revendication 5, dans lequel l'unité de conversion de CLD convertit le gain de puissance commandé en valeur de CLD sur la base de l'équation 8 exprimée par :

$$D_{CLD}^{modified}(0,l,m) = 20\log_{10}\left(\frac{pG_{Lf}(l,m)}{pG_{Ls}(l,m)}\right)$$

$$D_{CLD}^{modified}(1,l,m) = 20\log_{10}\left(\frac{pG_{Rf}(l,m)}{pG_{Rs}(l,m)}\right)$$

$$D_{CLD}^{modified}(2,l,m) = 10\log_{10}\left(\frac{pG_{Lf}^2(l,m) + pG_{Ls}^2(l,m)}{pG_{Rf}^2(l,m) + pG_{Rs}^2(l,m)}\right)$$

$$D_{CLD}^{modified}(3,l,m) = 20\log_{10}\left(\frac{pG_{C}(l,m)}{pG_{lfe}(l,m)}\right)$$

$$D_{CLD}^{modified}(4,l,m) = 10\log_{10}\left(\frac{pG_{Lf}^2(l,m) + pG_{Ls}^2(l,m) + pG_{Rf}^2(l,m) + pG_{Rs}^2(l,m)}{pG_{C}^2(l,m) + pG_{lfe}^2(l,m)}\right)$$

Equation 8

**10.** Appareil selon la revendication 1,
dans lequel un signal central (C), un signal de plan de moitié gauche (Lf+Ls) et un signal de plan de moitié droite (Rf+Rs) sont extraits des signaux mélangés- abaissés L0 et R0 sur la base de l'équation 9, et
des informations de repère spatial sont une valeur de différence de niveau de canal (CLD) représentant une différence de niveau entre des signaux audio d'entrée et exprimée par $CLD_{LR/Clfe}$, $CLD_{L/R}$, $CLD_{C/lfe}$ ; $CLD_{Lf/Ls}$ et $CLD_{Rf/Rs}$, et l'équation 9 étant exprimée par :

$$\mathbf{R}_1^{\prime\prime,m} = \begin{bmatrix} w_{11}^{\prime,m} & w_{12}^{\prime\prime,m} \\ w_{21}^{\prime\prime,m} & w_{22}^{\prime,m} \\ w_{31}^{\prime,m}\sqrt{2} & w_{32}^{\prime,m}\sqrt{2} \\ w_{11}^{\prime,m} & w_{12}^{\prime,m} \\ w_{21}^{\prime\prime,m} & w_{22}^{\prime,m} \end{bmatrix}, \quad 0 \le m < \mathbf{m}_{tttLowProc}(0), 0 \le l < L$$

$$w_{12}^{\prime\prime,m} = \frac{P_{pan}^{L}}{\sqrt{P_C/2 + P_{Rf} + P_{Rs}}}$$

$$w_{21}^{\prime\prime,m} = \frac{P_{pan}^{R}}{\sqrt{P_C/2 + P_{Lf} + P_{Ls}}}$$

$$w_{13}^{\prime,m} = \frac{P_{pan}^{CL}}{\sqrt{Pc/2 + P_{Rf} + P_{Rs}}}$$

$$w_{31}^{\prime\prime,m} = \frac{P_{pan}^{CR}}{\sqrt{P_C/2 + P_{Lf} + P_{Ls}}}$$

$$\left(w_{11}^{\prime,m}\right)^2 + \left(w_{21}^{\prime,m}\right)^2 + \left(w_{31}^{\prime\prime,m}\right)^2 = 1$$

$$\left(w_{12}^{\prime\prime,m}\right)^2 + \left(w_{22}^{\prime\prime,m}\right)^2 + \left(w_{32}^{\prime\prime,m}\right)^2 = 1$$

Equation 9

où $w_{ij}^{l,m}$ est un coefficient généré à partir d'un gain de puissance calculé sur la base des valeurs de CLD ($CLD_{LR/Clfe}$, $CLD_{L/R}$, $CLD_{C/lfe}$ ; $CLD_{Lf/Ls}$ et $CLD_{Rf/Rs}$) (i et j sont des indices de matrices vectorielles ; m est un indice d'une sous-bande ; et 1 est un indice d'un ensemble de paramètres) ;

$m_{tttLowProc}$ est le nombre de sous-bandes ;

$P_c$, $P_{Lf}$, $P_{Ls}$, $P_{Rf}$, $P_{Rs}$ sont des gains de puissance d'un signal central, un signal avant gauche, un signal arrière gauche, un signal avant droit et un signal arrière droit ;

$PL_{pan}$ indique une puissance projetée sur la base d'une loi panoramique en proportion d'une combinaison de $P_C$, $P_{Lf}$, $P_{LS}$ ;

$PR_{pan}$ indique une puissance projetée sur la base d'une loi panoramique en proportion d'une combinaison de $P_C$, $P_{Rf}$, $P_{Rs}$ ; et

$PCL_{pan}$ et $PCR_{pan}$ sont des gains de puissance panoramique respectivement pour un plan de moitié gauche et un plan de moitié droite par rapport à un canal central.

**11.** Appareil selon la revendication 10, dans lequel l'unité de conversion de facteur extrait des gains de puissance ($P_c$, $P_{Lf}$, $P_{Ls}$, $P_{Rf}$, $P_{Rs}$) des signaux audio d'entrée sur la base de valeurs de CLD ($CLD_{LR/Clfe}$, $CLD_{L/R}$, $CLD_{C/lfe}$ ; $CLD_{Lf/Ls}$ et $CLD_{Rf/Rs}$) .

**12.** Appareil selon la revendication 11, dans lequel l'unité de commande de facteur de gain calcule en outre les gains de puissance ($PL_{pan}$, $PR_{pan}$, $PCL_{pan}$ et $PCR_{pan}$) en commandant les gains de puissance ($P_c$, $P_{Lf}$, $P_{Ls}$, $P_{Rf}$, $P_{Rs}$) des signaux audio d'entrée extraits dans l'unité de conversion de facteur de gain sur la base d'informations de commande sur la restitution des signaux audio d'entrée, et

des gains de puissance commandés sont calculés sur la base du gain de puissance obtenu ($P_c$, $P_{Lf}$, $P_{Ls}$, $P_{Rf}$, $P_{Rs}$, $PL_{pan}$, $PR_{pan}$, $PCL_{pan}$ et $PCR_{pan}$).

**13.** Appareil selon la revendication 12, dans lequel les gains de puissance commandés sont calculés sur la base de l'équation 10 exprimée par :

$$_{out}g_m^{Lf} = \sqrt{P_{Lf} + P_{pan}^L}$$

$$_{out}g_m^{Ls} = \sqrt{P_{Ls}}$$

$$_{out}g_m^{Rf} = \sqrt{P_{Rf} + P_{pan}^R}$$

$$_{out}g_m^{Rs} = \sqrt{P_{Rs}}$$

$$_{out}g_m^{CL} = \sqrt{P_C/2}$$

$$_{out}g_m^{CR} = \sqrt{P_C/2}$$

Equation 10

**14.** Appareil destiné à commander la restitution de signaux audio, comprenant :

un moyen de décodage (201) pour décoder un signal audio d'entrée, qui est un signal mélangé-abaissé qui est codé dans un procédé de codage audio spatial (SAC), en utilisant un procédé de décodage SAC ; et
un moyen de restitution de repère spatial (203) pour recevoir des informations de repère spatial et des informations de commande sur la restitution du signal audio d'entrée et commander les informations de repère spatial dans un domaine de repère spatial sur la base des informations de commande,
dans lequel le moyen de décodage effectue la restitution des signaux audio d'entrée sur la base d'informations de repère spatial commandées qui sont commandées par le moyen de restitution de repère spatial,
dans lequel les informations de repère spatial sont une différence de niveau de canal (CLD) indiquant une différence de niveau entre les signaux audio d'entrée et un coefficient de prédiction de canal (CPC) indiquant un taux de mélange-abaissement des signaux audio d'entrée, et
le moyen de restitution de repère spatial comprend :

une unité d'analyse syntaxique de CPC/CLD (701) pour extraire un paramètre de CPC et un paramètre de CLD à partir d'un CPC et d'une CLD transmis depuis un moyen de codage ;
une unité de conversion de facteur de gain (703) pour extraire des gains de puissance de chaque signal en extrayant un signal central, un signal de plan de moitié gauche et un signal de plan de moitié droite à partir du paramètre de CPC extrait dans l'unité d'analyse syntaxique de CPC/CLD, et en extrayant des gains de puissance des composantes de signal de gauche et des composantes de signal de droite à partir du paramètre de CLD ; et
une unité de commande de facteur de gain (705) pour calculer un gain de puissance commandé en commandant un gain de puissance de chaque signal audio extrait dans l'unité de conversion de facteur de gain sur la base des informations de commande sur la restitution du signal audio d'entrée,
une unité de conversion de CLD (707) pour convertir le gain de puissance commandé délivré par l'unité de commande de facteur de gain en une valeur de CLD, dans lequel
le moyen de décodage utilise la valeur de CLD acquise à partir de la conversion dans l'unité de conversion de CLD en tant qu'informations spatiales commandées nécessaires pour effectuer la restitution du signal audio d'entrée.

**15.** Appareil selon la revendication 14, dans lequel l'unité de conversion de facteur de gain extrait un signal central, un signal de plan de moitié gauche, et un signal de plan de moitié droite à partir du paramètre de CPC extrait dans l'unité d'analyse syntaxique de CPC/CLD sur la base de l'équation 11 exprimée par :

$$M_{PDC} \begin{bmatrix} l_0 \\ r_0 \end{bmatrix} = \begin{bmatrix} l \\ r \\ c \end{bmatrix}$$

$$M_{PDC} = \begin{bmatrix} c_{11} & c_{12} \\ c_{21} & c_{22} \\ c_{31} & c_{32} \end{bmatrix}$$

Equation 11

où $l_0$, $r_0$, l, r, c indiquent des signaux audio d'entrée $L_0$ et $R_0$, un signal de plan de moitié gauche (LS+Lf), un signal de plan de moitié droite (Rf+Rs) et un signal central (C) ; et $M_{PDC}$ indique un vecteur de paramètre de CPC extrait dans l'unité d'analyse syntaxique de CPC/CLD.

**16.** Appareil selon la revendication 15, dans lequel le paramètre de CLD extrait dans l'unité d'analyse syntaxique de CPC/CLD est des informations de différence de niveau entre des composantes de signal de gauche et des informations de différence de niveau entre des composantes de signal de droite, et

l'unité de conversion de facteur de gain calcule les gains de puissance des composantes de signal de gauche (Ls, Lf) et les gains de puissance des composantes de signal de droite (Rf, Rs) à partir du signal central extrait, du signal de plan de moitié gauche et du signal de plan de moitié droite sur la base du paramètre de CLD.

**17.** Appareil selon la revendication 16, dans lequel l'unité de commande de facteur de gain calcule un gain de puissance commandé ($_{out}G_m$) exprimé par l'équation 12 en commandant le gain de puissance du signal audio d'entrée extrait dans l'unité de conversion de facteur de gain sur la base des informations de commande sur la restitution du signal audio d'entrée selon une loi panoramique, l'équation 12 étant exprimée par :

$$_{out}G_m = \begin{bmatrix} _{out}g_m^1 \\ _{out}g_m^2 \\ \vdots \\ _{out}g_m^M \end{bmatrix} = [\alpha, \beta]_{M \times N} G_m$$

Equation 12

où $G_m$ indique un vecteur de gain de puissance d'un signal audio d'entrée ;
$_{out}G_m$ indique un vecteur de gain de puissance commandé ;
M indique le nombre de signaux audio de sortie ;
N indique le nombre de signaux audio d'entrée ; et
$[\alpha, \beta]_{M \times N}$ indique un vecteur MxN composé de coefficients $\alpha_k$ et $\beta_k$ qui sont calculés pour mapper le signal audio d'entrée ($g_m^k$) à une position entre des signaux audio de sortie arbitraires.

**18.** Appareil selon la revendication 4 ou 17, dans lequel la loi panoramique est une loi panoramique à puissance constante (CPP), et les coefficients $\alpha_k$ et $\beta_k$ sont respectivement $\alpha_k = \cos(\theta_k)$, $\beta_k = \sin(\theta_k)$,
où $\theta_k$ est une information d'angle entre les signaux audio de sortie sur lesquels le signal audio d'entrée ($g_m^k$) est mappé.

**19.** Appareil selon la revendication 2 ou 14, dans lequel l'unité de conversion de CLD convertit le gain de puissance commandé en valeur de CLD sur la base de l'équation 13 exprimée par :

$$converted\ CLD^i_m = 20\log_{10}\frac{_{out}g^k_m}{_{out}g^j_m}$$

Equation 13

où la CLD$^i_m$ convertie est une valeur de CLD obtenue à partir de la conversion dans l'unité de conversion de CLD ;
i indique un indice de CLD ($1 \leq i \leq M - 1$) ;
M indique le nombre de signaux audio dans une m$^{ième}$ sous- bande ;
$_{out}g^k_m$ et $_{out}g^j_m$ indiquent des gains de puissance commandés respectivement pour les j$^{ième}$ et k$^{ième}$ signaux audio dans la m$^{ième}$ sous- bande.

**20.** Appareil selon la revendication 1,
dans lequel les informations de repère spatial sont une valeur de corrélation inter-canaux (ICC) représentant une corrélation entre des signaux audio d'entrée, et
le moyen de restitution de repère spatial commande un paramètre ICC par l'intermédiaire d'un procédé d'interpolation linéaire sur la base de l'équation 14 exprimée par :

$$ICC_{Ls.Lf} = (1-\eta)ICC_{Ls.Lf} + \eta ICC_{Rs.Rf}$$
$$ICC_{Rs.Rf} = (1-\eta)ICC_{Rs.Rf} + \eta ICC_{Ls.Lf}$$

$$\eta = \frac{\theta_{pan}}{\pi}, \quad \theta_{pan} \leq \pi$$

$$\eta = 1 - \frac{\theta_{pan} - \pi}{\pi}, \quad \theta_{pan} > \pi$$

Equation 14

où $\theta_{pan}$ indique des informations de commande sur la restitution du signal audio d'entrée.

**21.** Appareil selon l'une des revendications 1, 5, 10, 14 ou 20, dans lequel le moyen de décodage délivre un signal stéréo binaural selon un procédé de décodage binaural auquel un coefficient HRTF est appliqué.

**22.** Procédé destiné à commander la restitution de signaux audio, comprenant les étapes de :

a) décodage d'un signal audio d'entrée, qui est un signal mélangé-abaissé qui est codé dans un procédé de codage audio spatial (SAC), en utilisant un procédé de décodage SAC ; et
b) réception d'informations de repère spatial et d'informations de commande sur la restitution des signaux audio d'entrée et la commande des informations de repère spatial dans un domaine de repère spatial sur la base des informations de commande,

dans lequel la restitution est effectuée à l'étape a) de décodage sur les signaux audio d'entrée sur la base d'informations de repère spatial commandées à l'étape b) de restitution de repère spatial, de telle manière que
les informations de repère spatial sont une différence de niveau de canal (CLD) indiquant un niveau différent parmi les signaux audio d'entrée ; et
l'étape b) de restitution de repère spatial comprend les étapes de :

b1) extraction d'un paramètre de CLD à partir de la CLD transmise depuis un moyen de codage ;

b2) extraction d'un gain de puissance de chaque signal audio à partir du paramètre de CLD extrait à l'étape b1) d'analyse syntaxique de CLD ; et

b3) calcul d'un gain de puissance commandé en commandant le gain de puissance de chaque signal audio extrait à l'étape b2) de conversion de facteur de gain sur la base des informations de commande sur la restitution des signaux audio d'entrée ; et

b4) conversion du gain de puissance commandé délivré à l'étape b3) de commande de facteur de gain en une valeur de CLD, et

l'étape de décodage a) utilise la valeur de CLD acquise à partir de la conversion à l'étape b4) de conversion de CLD en tant qu'informations spatiales commandées nécessaires pour effectuer la restitution du signal audio d'entrée.

23. Procédé destiné à commander la restitution de signaux audio, comprenant les étapes de :

a) décodage d'un signal audio d'entrée, qui est un signal mélangé-abaissé qui est codé dans un procédé de codage audio spatial (SAC), en utilisant le procédé de décodage SAC ; et

b) réception d'informations de repère spatial et d'informations de commande sur la restitution du signal audio d'entrée et la commande des informations de repère spatial dans un domaine de repère spatial sur la base des informations de commande,

dans lequel la restitution du signal audio d'entrée est effectuée à l'étape a) de décodage sur la base d'informations de repère spatial commandées à l'étape b) de restitution de repère spatial, et

les informations de repère spatial sont un coefficient de prédiction de canal (CPC) indiquant un taux de mélange-abaissement des signaux audio d'entrée et une différence de niveau de canal (CLD) indiquant une différence de niveau entre les signaux audio d'entrée, et

l'étape b) de restitution de repère spatial comprend :

b1) l'extraction d'un paramètre de CPC et d'un paramètre de CLD à partir d'un CPC et d'une CLD transmis depuis un moyen de codage ; b2) l'extraction des gains de puissance de chaque signal en extrayant un signal central, un signal de plan de moitié gauche et un signal de plan de moitié droite à partir du paramètre de CPC extrait à l'étape b1) d'analyse syntaxique de CPC/CLD, et en extrayant un gain de puissance d'une composante de signal de gauche et d'une composante de signal de droite à partir du paramètre de CLD ; et

b3) le calcul d'un gain de puissance commandé en commandant un gain de puissance de chaque signal audio extrait à l'étape b2) de conversion de facteur de gain sur la base des informations de commande sur la restitution du signal audio d'entrée,

b4) la conversion du gain de puissance commandé délivré à l'étape b3) de commande de facteur de gain en une valeur de CLD, et la valeur de CLD acquise à partir de la conversion à l'étape b4) de conversion de CLD est utilisée à l'étape a) de décodage en tant qu'informations spatiales commandées nécessaires pour effectuer la restitution du signal audio d'entrée.

## FIG. 1

input audio signal 1 → | SAC Encoder | → Transmitted Signal (mono/stereo)
input audio signal 2 →
input audio signal 3 →
input audio signal 4 →

101

Spatial Cues →

## FIG. 2

Transmitted Signal (mono/stereo) → SAC Decoder → output audio signal 1
→ output audio signal 2
→ output audio signal 3
→ output audio signal 4

203

Spatial Cue → Spatial Cue Renderer

201

Interaction control /Sound Scene information

FIG. 3

# FIG. 4

Spatial Cue →

**401**
CLD Parsing unit

→

**403**
Gain Factor Conversion unit

→

**405**
Gain Factor Control unit

→

**407**
CLD Conversion unit

→ Converted Spatial Cues

201

Converted Gain Factors →

Interaction control /Sound Scene information

# FIG. 5

output signal 1
virtual position

input signal 1
virtual position

Aperture

$\beta = \sin(\theta)$

$\theta$

output signal 2
virtual position

$\alpha = \cos(\theta)$

FIG. 6

FIG. 7

LO

RO

201

Converted
Gain Factors

Spatial Cues

701
CPC/CLD
Parsing
unit

703
Gain Factor
Conversion
unit

705
Gain Factor
Control
unit

707
CLD
Conversion
unit

Converted
Spatial Cues

Interaction control
/Sound Scene
information

FIG. 8

# FIG. 9

Down-mixed signal (mono/stereo) → SAC Decoder (before Inverse T/F) [903] → Panning Rendering Tool [905] → Parameter Based HRTF Rendering Tool [907] → Inverse T/F [909] → Output signals

Spatial Cue → Panning Tool [901]

Interaction Control

FIG. 10

QMF domain down-mix signal

FIG. 11

# FIG. 12

Transmitted signal
(mono/stereo)

1205

SAC
Decoder

→ output audio
signal

Modified SI
(Converted Spatial Cue)

Side Information
(Spatial Cue)

SI
Decoder

1201

Spatializer

1203

Interaction
control($\Delta\delta$)

# FIG. 13

1203

Spatializer

CLD

Virtual
Position
Estimation
unit

1301

CLD
Conversion
unit

1303

→ Modified CLD

$\Delta\delta$

FIG. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Text of ISO/IEC 23003-1: 200x MPEG Surround. *74. MPEG MEETING,* 21 October 2005

- **HAN-GIL MOON.** Multi-channel audio compression method with virtual source location information for MPEG-4 SAC. *The thesis,* 01 February 2005